# EUROPEAN PATENT APPLICATION

(11) **EP 4 318 551 A1**
(43) Date of publication of application: **07.02.2024**
(21) Application number: 22781067.8
(22) Date of filing: 30.03.2022
(51) Int. Cl.: H01L 21/02, H01L 21/677, H01L 21/683

(54) **BONDING DEVICE, BONDING SYSTEM, AND BONDING METHOD**

(30) Priority: 31.03.2021 JP 2021060026
(71) Applicant: Bondtech Co., Ltd., Minami-ku Kyoto-shi Kyoto 601-8366 (JP)
(72) Inventor: YAMAUCHI, Akira, Kyoto-shi Kyoto 601-8366 (JP)
(74) Representative: Rüger Abel Patentanwälte PartGmbB
(86) International application number: PCT/JP2022/015898
(87) International publication number: WO 2022/210857

(57) **Abstract**

A bonding device (1) includes a stage (141) to hold a substrate (W1), a head (142) arranged facing the stage (141) and configured to hold a substrate (W2), a head holder (111) to hold the head (142) on the opposite side to the stage (141) side of the head (142), the head holder (111) extending to the outer side of the head (142) and the stage (141) in a direction orthogonal to the Z-axis direction, three holder supports (1471) each to support the head holder (111) from one of three locations in an outer peripheral portion surrounding the stage (141), and three support drivers (146) to individually move the three holder supports (1471) in a -Z-direction in which the head holder (111) and the stage (141) come close to each other or a +Z-direction in which the head holder (111) and the stage (141) separate from each other.

## Description

### Technical Field

The present disclosure relates to a bonding device, a bonding system, and a bonding method.

### Background Art

A bonding device that, after, while one of two objects to be bonded is held on a stage and the other is held on a head, measuring a misalignment amount between both objects to be bonded and performing position alignment of the objects to be bonded based on the misalignment amount, bonds the objects to be bonded to each other is proposed (see, for example, Patent Literature 1).

### Citation List

### Patent Literature

Patent Literature 1: Unexamined Japanese Patent Application Publication No. 2011-066287

### Summary of Invention

### Technical Problem

The bonding device described in Patent Literature 1 has a structure in which a Z-axis ascent/descent driving mechanism that causes the head to ascend and descend in the vertical direction is arranged vertically directly above the head and is supported by a support frame that erects from a base plate on which the stage is disposed. In this case, height from the ground on which the bonding device is placed to the Z-axis ascent/descent driving mechanism is caused to become high. This configuration causes vibration amplitude of the Z-axis ascent/descent driving mechanism and the head to become large, which causes relative vibration amplitude of the head with respect to the stage to become large. Therefore, alignment precision between two objects to be bonded and variation in a contact position at which the two objects to be bonded are brought into contact with each other become large, which causes positional precision when the two objects to be bonded are bonded to each other to deteriorate.

The present disclosure has been made in consideration of the above-described conditions, and an objective of the present disclosure is to provide a bonding device, a bonding system, and a bonding method capable of bonding substrates to each other with high positional precision.

### Solution to Problem

In order to achieve the above-described objective, a bonding device according to the present disclosure is
a bonding device for bonding a first substrate and a second substrate to each other and includes:
a stage to support the first substrate;
a head arranged facing the stage and configured to hold the second substrate on a side facing the stage;
a head holder to hold the head on an opposite side to the stage side of the head, the head holder extending to an outer side of the head and the stage in a direction orthogonal to an arrangement direction of the head and the stage;
a plurality of holder supports each to support the head holder from one of a plurality of locations in an outer peripheral portion surrounding the stage; and
a plurality of support drivers to individually move the plurality of holder supports in a first direction in which the head holder and the stage come close to each other or a second direction in which the head holder and the stage separate from each other.

A bonding method according to another aspect of the present disclosure is
a bonding method for bonding a first substrate and a second substrate to each other and includes:
by individually moving a plurality of holder supports each to support a head holder, the head holder being arranged facing a stage to hold the first substrate, holding a head to hold the second substrate on an opposite side to the stage side of the head, and extending to an outer side of the head and the stage in a direction orthogonal to an arrangement direction of the head and the stage, from one of a plurality of locations on an outer peripheral portion surrounding the stage in a first direction in which the head holder and the stage come close to each other or a second direction in which the head holder and the stage separate from each other, adjusting distances between a plurality of locations on a peripheral portion of the stage and a plurality of locations on the head each of which is opposed to one of a plurality of locations on a peripheral portion of the stage.

### Advantageous Effects of Invention

According to the present disclosure, each of a plurality of holder supports supports the head holder from one of a plurality of locations in an outer peripheral portion surrounding the stage, and the support drivers individually move the plurality of holder supports in the aforementioned first direction or the aforementioned second direction. Since this configuration enables distances of the stage and the head from the ground to be decreased, vibration amplitudes of the stage and the head can be reduced accordingly. Therefore, since misalignment caused by vibration is reduced, the first substrate and the second substrate can be bonded to each other with high positional precision accordingly.

### Brief Description of Drawings

FIG. 1 is a schematic configuration diagram of a substrate bonding system according to an embodiment of the present disclosure;
FIG. 2A is a schematic cross-sectional view of a portion of a bonding device and a transportation device according to the embodiment when a sealing member is in a second state;
FIG. 2B is a schematic cross-sectional view of the portion of the bonding device and the transportation device according to the embodiment when the sealing member is in a first state;
FIG. 3 is a schematic diagram of a sealing driver according to the embodiment;
FIG. 4 is a schematic front view of an activation treatment device according to the embodiment;
FIG. 5 is a schematic front view of the bonding device according to the embodiment;
FIG. 6A is a schematic plan view of a stage and a head according to the embodiment;
FIG. 6B is a schematic cross-sectional view of the stage and the head according to the embodiment;
FIG. 7 is a schematic plan view of the bonding device according to the embodiment;
FIG. 8A is a diagram for a description of a measurement method of distance between the stage and the head according to the embodiment;
FIG. 8B is a diagram for a description of a method for adjusting inclination of the head according to the embodiment;
FIG. 9A is a plan view of the stage and a stage base;
FIG. 9B is a diagram for a description of an operation of rotating the stage;
FIG. 10A is a diagram illustrating two alignment marks disposed on one of two substrates to be bonded to each other;
FIG. 10B is a diagram illustrating two alignment marks disposed on the other of the two substrates to be bonded to each other;
FIG. 11A is a schematic view illustrating a captured image of the alignment marks;
FIG. 11B is a schematic view illustrating a state in which the alignment marks are misaligned from each other;
FIG. 12 is a schematic diagram of a portion of the bonding device according to the embodiment;
FIG. 13 is a flowchart illustrating a flow of a bonding method that the bonding system according to the embodiment performs;
FIG. 14A is a diagram illustrating a manner in which a substrate is transported by a transportation device in the bonding system according to the embodiment;
FIG. 14B is a diagram illustrating a manner in which the substrate is handed over from the transportation device to a load lock device in the bonding system according to the embodiment;
FIG. 15A is a diagram illustrating a manner in which the substrate is handed over from the load lock device to another transportation device in the bonding system according to the embodiment;
FIG. 15B is a diagram illustrating a manner in which the substrate is handed over from the another transportation device to the activation treatment device in the bonding system according to the embodiment;
FIG. 16A is a diagram illustrating a manner in which the substrate is handed over from the another transportation device to the load lock device in the bonding system according to the embodiment;
FIG. 16B is a diagram illustrating a manner in which the substrate is handed over from the load lock device to the transportation device in the bonding system according to the embodiment;
FIG. 17A is a diagram illustrating a manner in which the substrate is handed over from the transportation device to a cleaning device in the bonding system according to the embodiment;
FIG. 17B is a diagram illustrating a manner in which the substrate is handed over from the cleaning device to the transportation device in the bonding system according to the embodiment;
FIG. 18A is a diagram illustrating a manner in which the substrate is handed over from the transportation device to another load lock device in the bonding system according to the embodiment;
FIG. 18B is a diagram illustrating a manner in which the substrate is handed over from the another load lock device to still another transportation device in the bonding system according to the embodiment;
FIG. 19A is a diagram illustrating a manner in which the sealing member of the bonding system according to the embodiment is brought into the first state;
FIG. 19B is a diagram illustrating a manner in which the substrate is transported to the bonding device by the still another transportation device in the bonding system according to the embodiment;
FIG. 20 is a flowchart illustrating a flow of a bonding step that the bonding device according to the embodiment performs;
FIG. 21A is a diagram illustrating a manner in which the bonding device according to the embodiment brings the head close to the stage;
FIG. 21B is a diagram illustrating a manner in which the bonding device according to the embodiment causes substrates to bend;
FIG. 22A is a diagram illustrating a manner in which the bonding device according to the embodiment brings the substrates into contact with each other;
FIG. 22B is a diagram illustrating a manner in which the bonding device according to the embodiment brings peripheral portions of the substrates into contact with each other;
FIG. 23A is a schematic diagram illustrating a comparative example in which a head driver is located on the vertically upper side of a head;
FIG. 23B is a schematic diagram illustrating another comparative example in which a head driver is located on the vertically lower side of a stage;
FIG. 23C is a schematic diagram of the bonding device according to the present embodiment;
FIG. 24 is a diagram illustrating frequency spectra of vibration amplitudes in the case where plate drivers of a vibration isolation unit according to the embodiment are operated and in the case where the plate drivers are suspended;
FIG. 25 is a schematic front view of a bonding device according to a variation;
FIG. 26 is a schematic front view of a bonding device according to the variation;
FIG. 27 is a flowchart illustrating a flow of a bonding method that a bonding system according to the variation performs;
FIG. 28 is a schematic diagram of a portion of a bonding device according to the variation
FIG. 29 is a schematic diagram of a portion of a bonding device and a transportation device according to the variation;
FIG. 30 is a schematic plan view of the bonding device according to the variation;
FIG. 31 is a schematic plan view of a bonding device according to the variation; and
FIG. 32 is a cross-sectional view of a portion of the bonding device according to the variation.

### Description of Embodiments

A bonding device and a bonding system according to an embodiment of the present disclosure is described below, referring to the drawings. The bonding device according to the present embodiment includes a stage to hold a first substrate, a head arranged facing the stage and configured to hold a second substrate on the side facing the stage, a head holder, a plurality of holder supports, and a plurality of support drivers. The head holder holds the head on the opposite side to the stage side of the head and extends to the outer side of the head and the stage in directions orthogonal to an arrangement direction of the head and the stage. In addition, each of the plurality of holder supports supports the head holder from one of a plurality of locations in an outer peripheral portion surrounding the stage. Further, the plurality of support drivers is arranged in the outer peripheral portion surrounding the stage and individually moves the plurality of holder supports in a first direction in which the head holder and the stage come close to each other or a second direction in which the head holder and the stage separate from each other.

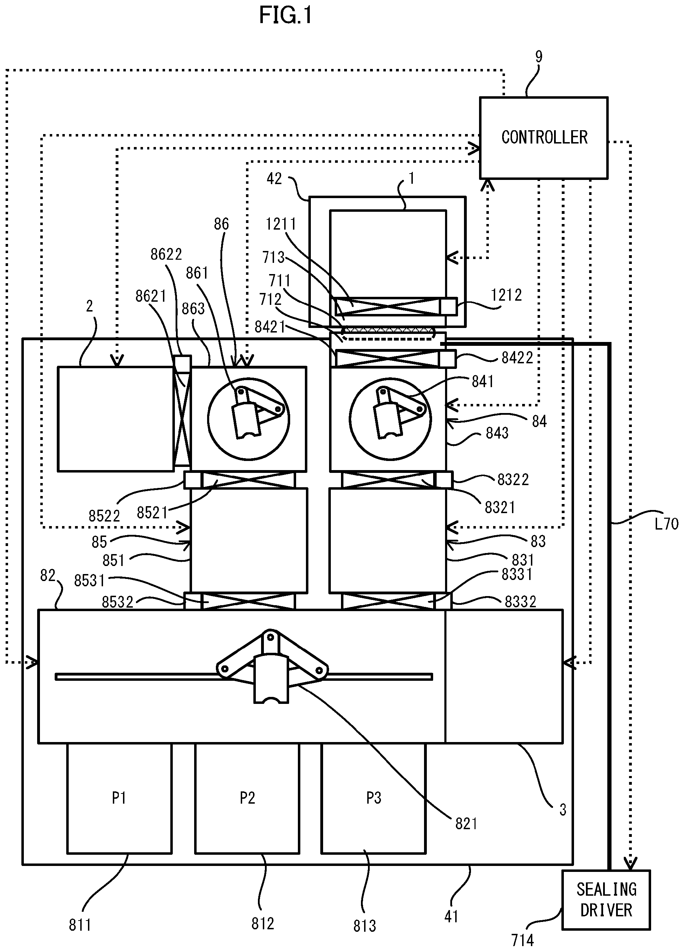

The bonding system according to the present embodiment includes feeding ports 811 and 812, a take-out port 813, transportation devices 82, 84, and 86, a cleaning device 3, an activation treatment device 2, a bonding device 1, load lock devices 83 and 85, and a controller 9 to control operation of the transportation devices 82, 84, and 86, the cleaning device 3, the activation treatment device 2, the bonding device 1, and the load lock devices 83 and 85, as illustrated in FIG. 1. In addition, the bonding system includes a first platform 42 to support the bonding device 1 and a second platform 41 that is different from the first platform 42 and is arranged separated from the first platform 42. The second platform 41 collectively supports the feeding ports 811 and 812, the take-out port 813, the transportation devices 82, 84, and 86, the cleaning device 3, the activation treatment device 2, and the load lock device 83 and 85. The first platform 42 is, for example, a quakeproof platform, and the second platform 41 is, for example, a platform on the vertically upper side of which a grating is installed.

The transportation device 82 includes a transportation robot 821 including an arm at the tip portion of which a holder to hold a substrate is disposed. The transportation robot 821 is capable of moving along an arrangement direction in which the feeding ports 811 and 812 and the take-out port 813 are arranged and also capable of changing the direction of the tip portion of the arm by turning. In the transportation device 82, a high efficiency particulate air (HEPA) filter (not illustrated) is installed. Because of this configuration, the inside of the transportation device 82 is maintained in an atmospheric pressure environment in which the number of particles is extremely small.

The cleaning device 3 cleans a transported substrate while discharging water, cleaning fluid, or N₂ gas to the substrate. The cleaning device 3 includes a stage (not illustrated) to support a substrate, a rotation driver (not illustrated) to rotate the stage in a plane orthogonal to the vertical direction, and a cleaning nozzle (not illustrated) to discharge water, cleaning fluid, or N₂ gas to which ultrasonic waves or megasonic vibration is applied. The cleaning device 3, by rotating the stage while swinging the cleaning nozzle in a radial direction of a substrate W1 or W2 and spraying water to which ultrasonic waves are applied on a bonding surface of the substrate from the cleaning nozzle, cleans the entire bonding surface of the substrate W1 or W2. The cleaning device 3, by rotating the stage while the discharge of water by the cleaning nozzle is suspended, spin-dries the substrate W1 or W2. In the cleaning device 3, as with the transportation device 82, a HEPA filter (not illustrated) is also installed.

The load lock device 83 includes a chamber 831, an exhaust pipe (not illustrated) communicating with the inside of the chamber 831, a vacuum pump (not illustrated) to exhaust gas in the chamber 831 through the exhaust pipe, and an exhaust valve (not illustrated) interposed in the exhaust pipe. The load lock device 83, by putting the exhaust valve into the open state and causing the vacuum pump to operate and thereby exhausting gas in the chamber 831 to the outside of the chamber 831 through the exhaust pipe, reduces (decompresses) gas pressure in the chamber 831. The load lock device 83 also includes a gate 8331 arranged on the transportation device 82 side of the chamber 831, a gate 8321 arranged on the transportation device 84 side of the chamber 831, and gate drivers 8332 and 8322 to drive opening and closing of the gates 8331 and 8321, respectively. In addition, the load lock device 83 includes an alignment mechanism (not illustrated) to adjust an attitude of the substrate W1 or W2 in the chamber 831. The gates 8331 and 8321 are disposed in such a manner as to cover an opening (not illustrated) provided in a penetrating manner on the transportation device 82 side of the chamber 831 and an opening (not illustrated) provided in a penetrating manner on the transportation device 84 side of the chamber 831, respectively. In addition, the load lock device 83 includes a chamber 831, an exhaust pipe (not illustrated) communicating with the inside of the chamber 831, a vacuum pump (not illustrated) to exhaust gas in the chamber 831 through the exhaust pipe, and an exhaust valve (not illustrated) interposed in the exhaust pipe. The load lock device 83, by putting the exhaust valve into the open state and causing the vacuum pump to operate and thereby exhausting gas in the chamber 831 to the outside of the chamber 831 through the exhaust pipe, reduces (decompresses) gas pressure in the chamber 831. The load lock device 83 also includes a gate 8331 arranged on the transportation device 82 side of the chamber 831, a gate 8321 arranged on the transportation device 84 side of the chamber 831, and gate drivers 8332 and 8322 to drive opening and closing of the gates 8331 and 8321, respectively. The gate drivers 8332 and 8322 drive opening and closing of the gates 8331 and 8321, based on a control signal input from the controller 9, respectively. In addition, the load lock device 85, as with the load lock device 83, includes a chamber 851, an exhaust pipe (not illustrated), a vacuum pump (not illustrated), and an exhaust valve (not illustrated). The load lock device 85 also includes a gate 8531 arranged on the transportation device 82 side of the chamber 851, a gate 8521 arranged on the transportation device 86 side of the chamber 851, and gate drivers 8532 and 8522 to drive opening and closing of the gates 8531 and 8521, respectively. The gate drivers 8532 and 8522 drive opening and closing of the gates 8531 and 8521, based on a control signal input from the controller 9, respectively.

The transportation device 84 is transportation means that includes a chamber 843, an exhaust pipe (not illustrated) communicating with the inside of the chamber 843, a vacuum pump (not illustrated) to exhaust gas in the chamber 831 through the exhaust pipe, an exhaust valve (not illustrated) interposed in the exhaust pipe, and a transportation robot 841 to transport the substrates W1 and W2. In addition, the transportation device 84, by putting the exhaust valve into the open state and causing the vacuum pump to operate and thereby exhausting gas in the chamber 831 to the outside of the chamber 831 through the exhaust pipe, maintains the inside of the chamber 831 in a reduce-pressure state. In addition, the transportation device 84 includes a gate 8421 arranged on the bonding device 1 side of the chamber 843 and a gate driver 8422 to drive opening and closing of the gate 8421. The chamber 843 includes an opening (not illustrated) provided in a penetrating manner on the bonding device 1 side and an opening (not illustrated) provided in a penetrating manner on the load lock device 83 side. The gate 8421 is a second gate that is installed on a portion of the chamber 843 in such a manner as to cover the opening (not illustrated) provided in a penetrating manner on the bonding device 1 side of the chamber 843. The gate driver 8421 puts the gate 8421 into the open state when the transportation robot 841 transports the substrate W1 or W2 into the bonding device 1. In addition, the opening provided in a penetrating manner on the load lock device 83 side of the chamber 843 is covered by the gate 8321 of the load lock device 83. The transportation robot 841 includes an arm at the tip portion of which a holder to hold a substrate is disposed and is capable of changing the direction of the tip portion of the arm by turning. In addition, the holder is, for example, an electrostatic chuck and sucks and holds the opposite side to the bonding surface side of the substrate W1 or W2.

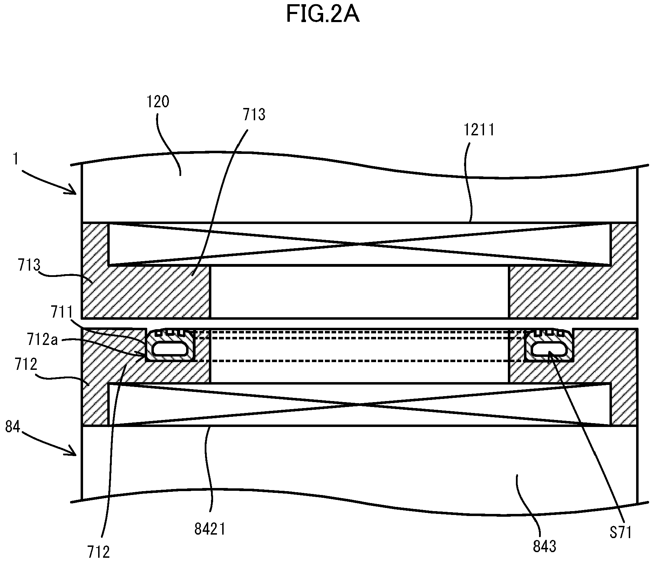

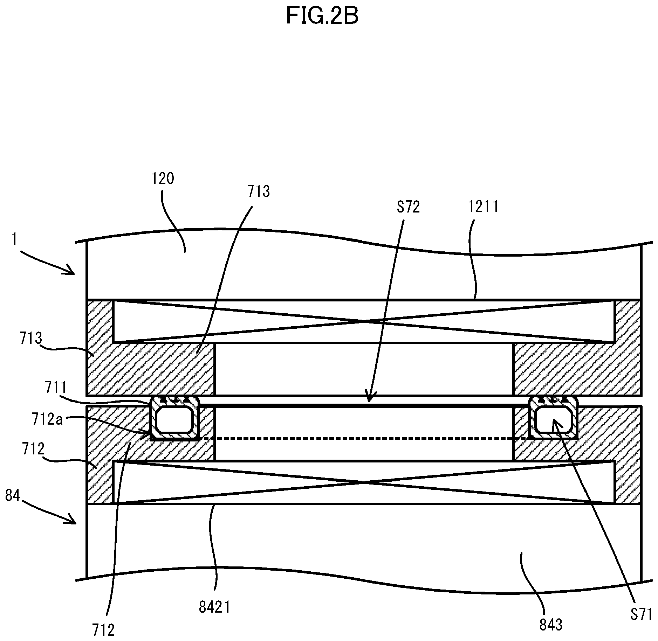

In addition, the transportation device 84 includes a frame body 712 disposed in such a manner as to surround the gate 8421 on the outer side of the chamber 843 and a sealing member 711 that is formed in an annular shape and is arranged over the entire circumference of the frame body 712 on the side of the frame body 712 that faces a frame body 713 of the bonding device 1, which is described later, as illustrated in FIG. 2A. The frame body 712 is a second frame body that faces the frame body 713 and is arranged separated from the frame body 713. On the side of the frame body 712 on which a surface facing the frame body 713 is located, a groove 712a into which the sealing member 711 is fitted is formed over the entire circumference. The sealing member 711 is formed of, for example, synthetic rubber into a tubular shape and has, on the inside thereof, a filling space S71 that is filled with a fluid, such as air and gas other than air. The sealing member 711 expands by the filling space S71 on the inside thereof being filled with a fluid and is brought into a first state in which the sealing member 711 comes into close contact with the frame body 713 and seals a space S72 between the frame body 713 and the frame body 712, as illustrated in FIG. 2B. On the other hand, the sealing member 711 contracts by the fluid in the filling space S72 on the inside thereof being discharged and is brought into a second state in which the sealing member 711 is separated from the frame body 713.

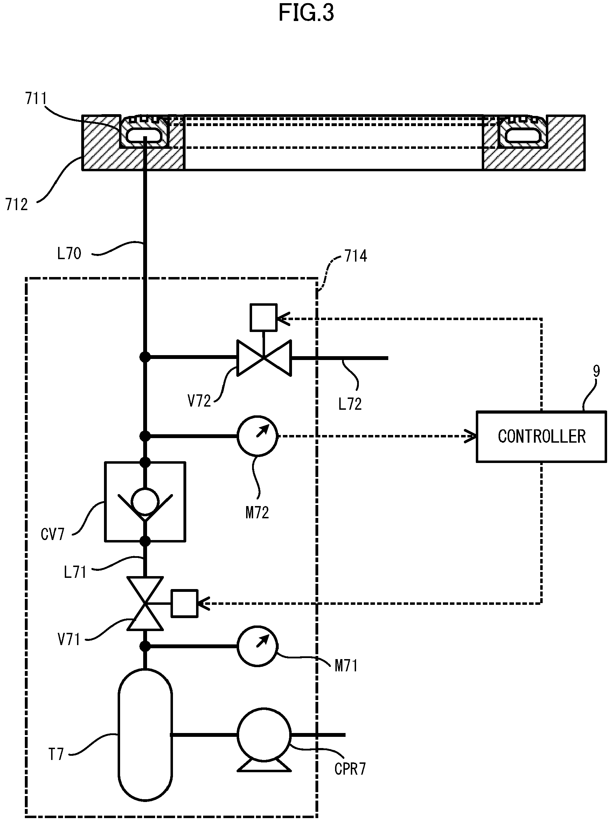

Further, the transportation device 84 includes a sealing driver 714 to fill the filling space S71 of the sealing member 711 with gas or discharge gas with which the filling space S71 is filled in such a way that the sealing member 711 is brought into either the aforementioned first state or second state. The sealing driver 714 includes a feed/discharge pipe L70 one end portion of which communicates with the filling space S71 on the inside of the sealing member 711, a check valve CV7 connected to the other end portion of the feed/discharge pipe L70, and a feed pipe L71 one end portion and the other end portion of which are connected to the check valve CV7 and a tank T7, respectively, as illustrated in, for example, FIG. 3. The sealing driver 714 also includes a compressor CPR7 to supply gas into the tank T7, an electromagnetic valve V71 interposed in the feed pipe L71, and a pressure gauge M71 to measure pressure inside the feed pipe L71. The sealing driver 714 further includes a discharge pipe L72 connected to the feed/discharge pipe L70, an electromagnetic valve V72 interposed in the discharge pipe L72, and a pressure gauge M72 to measure pressure inside the feed/discharge pipe L70. In this configuration, the compressor CPR7 supply gas into the tank T7 in such a way that pressure measured by the pressure gauge M71 is maintained at a preset pressure. In addition, the controller 9 controls the electromagnetic valves V71 and V72, based on pressure measured by the pressure gauge M72. Specifically, the controller 9, by filling the filling space S71 of the sealing member 711 with gas through putting the electromagnetic valve V72 into the closed state and also putting the electromagnetic valve V71 into the open state, causes the sealing member 711 to change from the second state to the first state. On the other hand, the controller 9, by discharging gas with which the filling space S71 of the sealing member 711 is filled to the outside of the sealing member 711 through putting the electromagnetic valve V71 into the closed state and also putting the electromagnetic valve V72 into the open state, causes the sealing member 711 to change from the first state to the second state.

Returning to FIG. 1, the transportation device 86, as with the transportation device 84, includes a chamber 863, an exhaust pipe (not illustrated), a vacuum pump (not illustrated), an exhaust valve (not illustrated), and a transportation robot 861. In addition, the transportation device 86 includes a gate 8621 arranged on the activation treatment device 2 side of the chamber 863 and a gate driver 8622 to drive opening and closing of the gate 8621. The chamber 863 includes an opening (not illustrated) provided in a penetrating manner on the activation treatment device 2 side and an opening (not illustrated) provided in a penetrating manner on the load lock device 85 side. The gate 8621 is installed in such a manner as to cover the opening (not illustrated) provided in a penetrating manner on the activation treatment device 2 side of the chamber 861. In addition, the opening provided in a penetrating manner on the load lock device 85 side of the chamber 861 is covered by the gate 8521 of the load lock device 85. The transportation robot 861, as with the transportation robot 841, includes an arm at the tip portion of which a holder to hold a substrate is disposed and is capable of changing the direction of the tip portion of the arm by turning. In addition, the holder is, for example, an electrostatic chuck and sucks and holds the opposite side to the bonding surface side of the substrate W1 or W2.

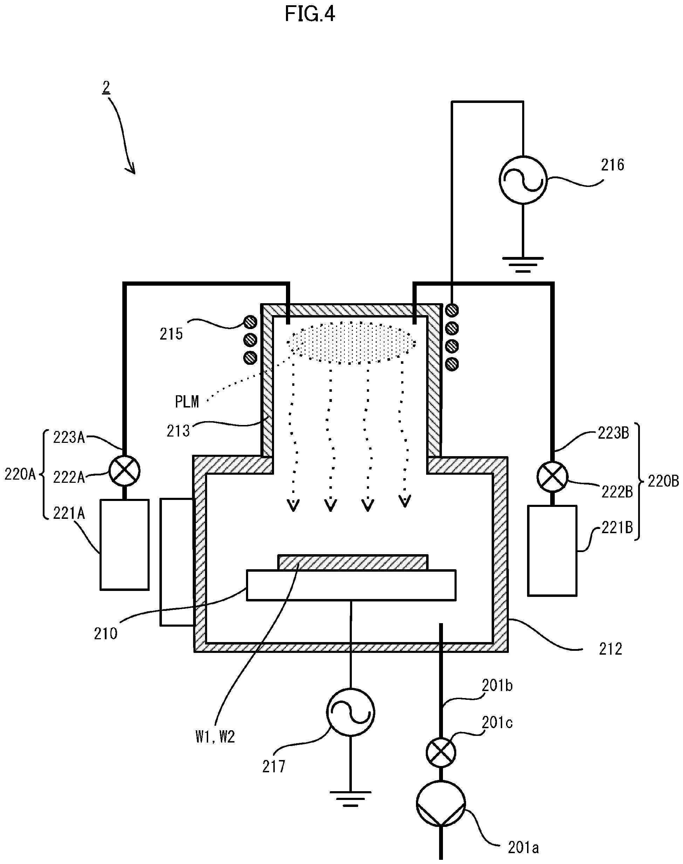

The activation treatment device 2, by subjecting the bonding surface of a substrate to at least one of reactive ion etching using nitrogen gas and irradiation of nitrogen radicals, performs activation treatment to activate the bonding surface. The activation treatment device 2 is a device that generates inductively coupled plasma (ICP) and, as illustrated in FIG. 4, includes a stage 210, a treatment chamber 212, a plasma chamber 213, an induction coil 215 wound on the outer side of the plasma chamber 213, and a high-frequency power source 216 to supply high-frequency current to the induction coil 215. The plasma chamber 213 is formed of, for example, quartz glass. The activation treatment device 2 also includes a nitrogen gas feeder 220A and an oxygen gas feeder 220B. The nitrogen gas feeder 220A includes a nitrogen gas storage 221A, a feeding valve 222A, and a feeding pipe 223A. The oxygen gas feeder 220B includes an oxygen gas storage 221B, a feeding valve 222B, and a feeding pipe 223B. On the stage 210, the substrate W1 or W2 is placed. The treatment chamber 212 communicates with the inside of the plasma chamber 213. The treatment chamber 212 is connected to a vacuum pump 201a via an exhaust pipe 201b and an exhaust valve 201c. The activation treatment device 2, by putting the exhaust valve 201c into the open state and causing the vacuum pump 201a to operate and thereby exhausting gas in the treatment chamber 212 to the outside of the treatment chamber 212 through the exhaust pipe 202b, reduces (decompresses) gas pressure in the treatment chamber 212.

As the high-frequency power source 216, a power source that supplies the induction coil 215 with a high-frequency current having a frequency of, for example, 27 MHz can be employed. When high-frequency current is supplied to the induction coil 215 while N₂ gas has been fed into the plasma chamber 213, plasma PLM is formed in the plasma chamber 213. Since, on this occasion, ions contained in the plasma are trapped in the plasma chamber 213 by the induction coil 215, the activation treatment device 2 may have a configuration in which there is no trap plate at a portion between the plasma chamber 213 and the treatment chamber 212. The induction coil 215, the high-frequency power source 216, and the nitrogen gas feeder 220A constitute a plasma generation source that generates plasma PLM in the plasma chamber 213 and supplies the bonding surface of the substrate W1 or W2 supported by the stage 210 with N₂ radicals in the plasma. Note that, although an example in which the activation treatment device 2 is a device that includes the induction coil 215 and the high-frequency power source 216 and generates ICP is described herein, the activation treatment device 2 is not limited to the example, and the activation treatment device 2 may instead be a device that includes a flat plate electrode arranged outside the plasma chamber 213, a high-frequency power source electrically connected to the flat plate electrode, and a trap plate arranged at a portion between the plasma chamber 213 and the treatment chamber 212 and configured to trap ions in the plasma and generates capacitively coupled plasma (CCP). In this case, as the high-frequency power source, a power source that applies a high-frequency bias having a frequency of, for example, 27 MHz can be employed. Power supplied from the high-frequency power source into the plasma chamber is set to, for example, 250 W. A bias applier 217 is a high-frequency power source that applies a high-frequency bias to the substrate W1 or W2 supported by the stage 210. As the bias applier 217, a power source that generates a high-frequency bias having a frequency of, for example, 13.56 MHz can be employed. Applying a high-frequency bias to the substrate W1 or W2 by the bias applier 217 as described above causes a sheath region in which ions with kinetic energy repeatedly collide with the substrate W1 or W2 to be generated in a vicinity of the bonding surface of the substrate W1 or W2. The bonding surface of the substrate W1 or W2 is etched by ions with kinetic energy existing in the sheath region.

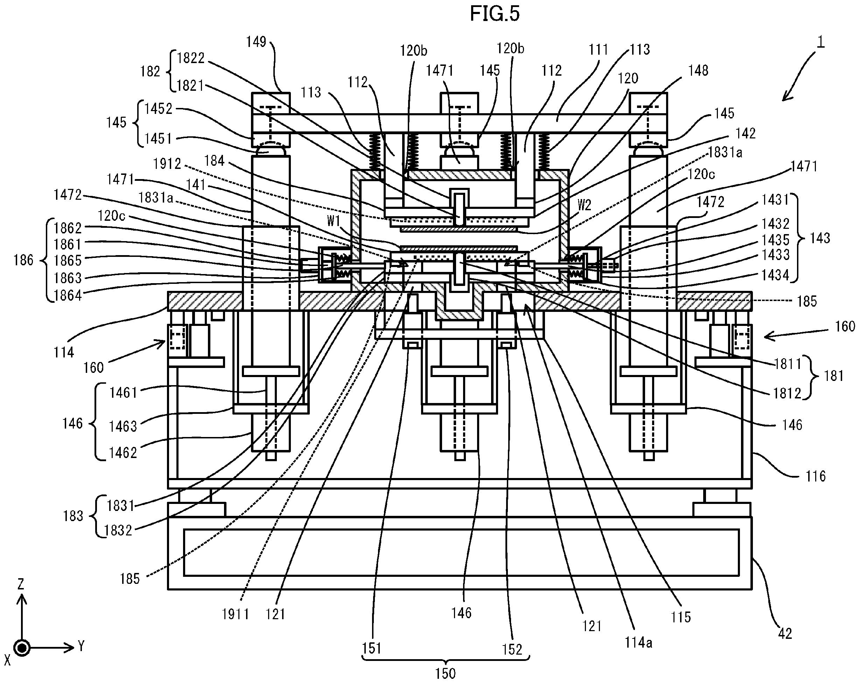

Returning to FIG. 1, the bonding device 1 bonds the substrates W1 and W2 the bonding surfaces of which, after having been subjected to the activation treatment in the activation treatment device 2, are cleaned by the cleaning device 3 to each other. The bonding device 1 includes a chamber 120, a stage 141, a head 142, a head holder 111, three holder supports 1471, couplers 145, locking mechanisms 149, three support drivers 146, stage drivers 143, air cylinders 186, distance measurers 185, substrate heaters 1911 and 1912, a position measurer 150, and a vibration isolation unit 160, as illustrated in FIG. 5. Note that the following description is made appropriately assuming that the ±Z-directions and an XY-direction in FIG. 5 are the vertical direction and a horizontal direction, respectively. The bonding device 1 also includes a top plate 114 to collectively support the chamber 120, the stage 141, the head 142, the head holder 111, the holder supports 1471, and the support drivers 146, the vibration isolation unit 160, and a base 116 mounted on the first platform 42.

The stage 141 and the head 142 are arranged in such a way that the stage 141 and the head 142 face each other in the vertical direction and the stage 141 is located on the -Z-direction side of the head 142 in the chamber 120. The stage 141 and the head 142 are formed of a translucent material, such as glass having translucency. On the stage 141 and the head 142, electrostatic chucks 1411 and 1412 that hold the substrates W1 and W2 are disposed, respectively, as illustrated in and 6A. The electrostatic chucks 1411 and 1412 are disposed in areas on the stage 141 and the head 142, the areas facing peripheral portions of the substrates W1 and W2 while the substrates W1 and W2 are held by the stage 141 and the head 142, and hold the peripheral portions of the substrates W1 and W2, respectively. Each of the electrostatic chucks 1411 and 1412 is formed in an annular shape and has terminal electrodes that are arranged along the circumferential direction of the stage 141 or the head 142 and a plurality of electrode elements that is formed in a linear shape and the base end portions of which are electrically connected to the terminal electrodes. The terminal electrodes and the pluralities of electrode elements are formed of a transparent conductive film containing a transparent conductive material, such as ITO. The electrostatic chucks 1411 and 1412 suck and hold the substrates W1 and W2 while voltage is applied to the electrostatic chucks 441 and 442 by chuck drivers (not illustrated), respectively. In addition, in the stage 141 and the head 142, recessed portions 141c and 142c are disposed on the inner sides of the electrostatic chucks 1411 and 1412, respectively, and, at the central portions of the stage 141 and the head 142, through-holes 141b and 142b that have a circular shape in plan view are disposed, respectively.

Further, the stage 141 and the head 142 are fixed to bases 183 and 184, respectively, as illustrated in and 6B. In the stage 141 and the head 142, the recessed portions 141c and 142c are disposed on the inner sides of the electrostatic chucks 1411 and 1412, respectively, and, at the central portions of the stage 141 and the head 142, the through-holes 141b and 142b that have a circular shape in plan view are disposed, respectively. At portions of the bases 183 and 184 corresponding to the through-holes 141b and 142b, through-holes 183b and 184b are disposed, respectively. The base 183 is fixed to the top plate 114 via a slider (not illustrated) that is freely slidable in the X-axis direction and the Y-axis direction and includes a lower-side base 1832 freely movable in the X-axis direction and the Y-axis direction and an upper-side base 1831 supported by the lower-side base 1832 in a freely rotatable manner in an XY-plane, as illustrated in FIG. 5. In addition, in the base 183, opening portions 1831a for causing light radiated from the position measurer 150 arranged on the -Z-direction side of the base 183 to be transmitted to the stage 141 side are formed. Further, to the base 183, a pressing mechanism 181 that presses a central portion of the substrate W1 is fixed, and to the base 184, a pressing mechanism 182 that presses a central portion of the substrate W2 is fixed.

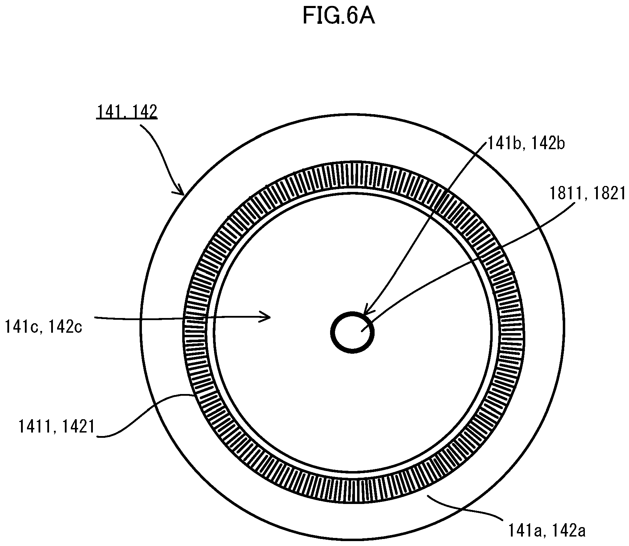

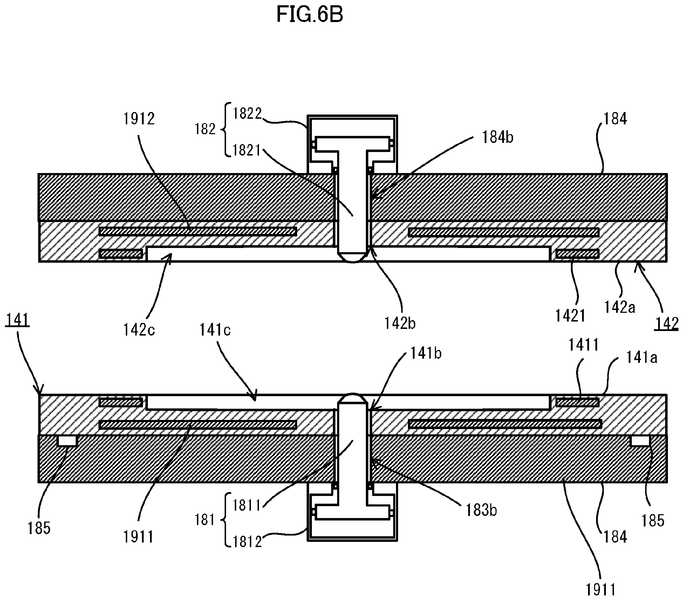

The pressing mechanism 181 includes a pressing rod 1811 that is projectable and retractable to and from the head 142 side through the through-hole 141b of the stage 141 and the through-hole 183b of the base 183 and a pressing driver 1812 that drives the pressing rod 1811, as illustrated in FIG. 6B. The pressing mechanism 182 also includes a pressing rod 1821 that is projectable and retractable to and from the stage 141 side through the through-hole 142b of the head 142 and the through-hole 184b of the base 184 and a pressing driver 1822 that drives the pressing rod 1821. Each of the pressing drivers 1812 and 1822 includes, for example, a voice coil motor.

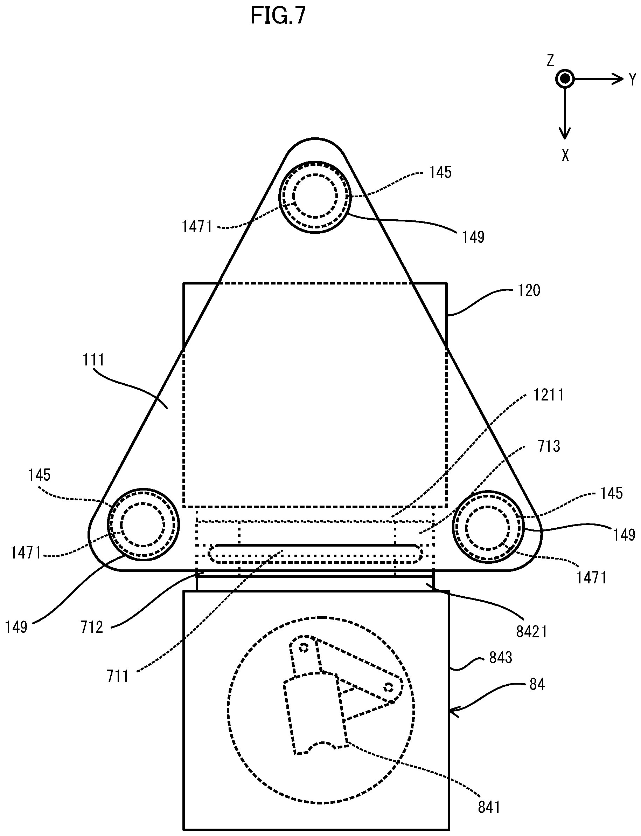

Returning to FIG. 5, the chamber 120 maintains a space S1 in which the substrates W 1 and W2 are arranged at a degree of vacuum greater than or equal to a preset reference degree of vacuum. The chamber 120 is connected to a vacuum pump (not illustrated) via an exhaust pipe (not illustrated) and an exhaust valve (not illustrated). When the exhaust valve is put into the open state and the vacuum pump is caused to operate, gas in the chamber 120 is exhausted to the outside of the chamber 120 through the exhaust pipe and the inside of the chamber 120 is maintained in a reduced pressure atmosphere. In addition, by varying an opening/closing amount of the exhaust valve and thereby adjusting an exhaust amount, gas pressure (a degree of vacuum) in the chamber 120 can be adjusted. On a portion of the chamber 120, two windows 121 that are used by the position measurer 150 to measure relative positions between the substrates W1 and W2 are disposed. In addition, on a portion of the chamber 120, an opening portion (not illustrated) for bringing in or taking out the substrates W1 and W2 is disposed. As illustrated in FIG. 7, a gate 1211 is disposed on the +X-direction side of the chamber 120 and covers the opening portion of the chamber 120.

The head holder 111 is formed in, for example, a plate shape having a triangular shape in plan view. The head holder 111 holds the head 142 and the base 184 via support members 112 on the opposite side to the stage 141 side of the head 142, that is, the +Z-direction side. The support members 112 are inserted into through-holes 120b that are formed in a peripheral wall on the +Z-direction side of the chamber 120. Spaces between outer peripheral portions of the through-holes 120b in the peripheral wall of the chamber 120 and outer peripheral portions of portions of the head holder 111 at which the support members 112 are fixed are sealed by bellows 113. In this configuration, between the base 184 and the support members 112, pressure sensors 148 to measure force exerted on the head 142 in a direction in which the head 142 comes close to the stage 141 are interposed. The head holder 111 extends to the outer side of the head 142 and the stage 141 in directions orthogonal to an arrangement direction of the head 142 and the stage 141, that is, the Z-axis direction, as illustrated in FIGS. 5 and 7.

Each of the three holder supports 1471 supports one of three corner portions of the head holder 111 from one of three locations in an outer peripheral portion surrounding the stage 141, as illustrated in FIG. 7. Each of the three holder supports 1471 is inserted into a cylindrical guide 1472 fixed to the top plate 114 and is supported by one of the support drivers 146 at an end on the -Z-direction side, as illustrated in FIG. 5.

Each of the couplers 145 is installed at an end on the head holder 111 side, that is, an end on the +Z-direction side, of one of the three holder supports 1471 and couples the one of the three holder supports 1471 to the head holder 11 while the head holder 111 is freely swingable with respect to the three holder supports 1471. Specifically, each of the couplers 145 includes a hemispherical engaging member 1451 disposed at the end on the +Z-direction side of one of the three holder supports 1471 and an engaged member 1452 disposed on the -Z-direction side of the head holder 111 and having a hemispherical recessed portion.

The locking mechanisms 149 are disposed at portions of the head holder 111 corresponding to the couplers 145 and can be switched between a locked state in which the locking mechanisms 149 fix the head holder 111 to the three holder supports 1471 and an unlocked state in which the locking mechanisms 149 maintain the head holder 111 in a freely swingable state with respect to the three holder supports 1471. When the locking mechanisms 149 are in the unlocked state, the head holder 111 is likely to be influenced by vibration. In addition, when the substrate W2 is pressed against the substrate W1 by moving the holder supports 1471 in the -Z-direction, only a pressure equivalent to self-weight of the head holder 111 can be applied. In contrast, putting the locking mechanisms 149 into the locked state and moving the holder supports 1471 in the -Z-direction by the support drivers 146 enable the substrate W2 to be pressed against the substrate W1.

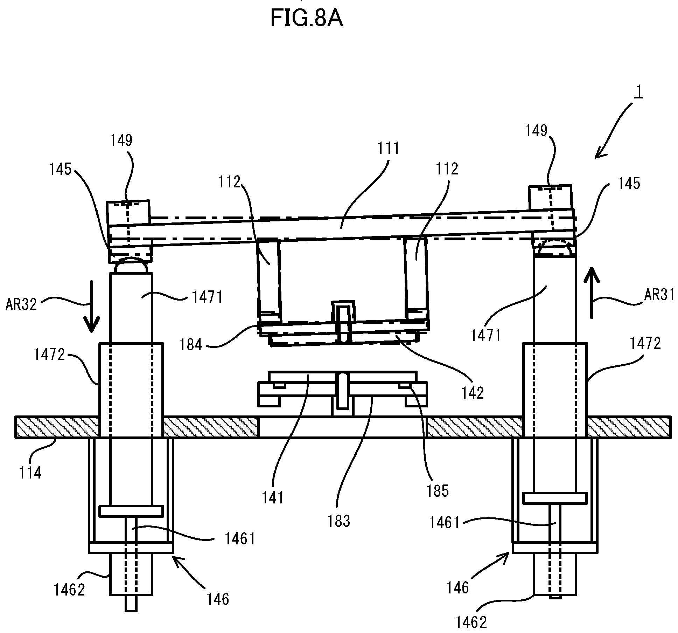

The three support drivers 146 are arranged on the outer side of the chamber 120 in the outer peripheral portion surrounding the stage 141. Each of the support drivers 146 includes a ball screw 1461, an actuator 1462 to drive the ball screw 1461 in the Z-axis direction, and a support member 1463 fixed to the top plate 114 and configured to support the actuator 1462. The ball screw 1461 has an end on the +Z-direction side in contact with the end on the -Z-direction side of one of the holder supports 1471, and when the actuator 1462 causes the ball screw 1461 to ascend and descend in the Z-axis direction, the holder support 1471 moves in the Z-axis direction in accordance with the ascent and descent. That is, the three support drivers 146 individually moves the three holder supports 1471 in the first direction in which the head holder 111 and the stage 141 come close to each other, that is, the -Z-direction, or the second direction in which the head holder 111 and the stage 141 separate from each other, that is, the +Z-direction. In addition, the three support drivers 146, by individually moving the three holder supports 1471 in the Z-axis direction, adjust distances between three locations on the peripheral portion of the stage 141 and three locations on the head 142 each of which is opposed to one of the three locations on the stage 141. When the locking mechanisms 149 are in the aforementioned unlocked state, the support drivers 146 are capable of adjusting inclination of the head holder 111 by, as illustrated in, for example, FIG. 8A, moving one holder support 1471 in the +Z-direction as illustrated by an arrow AR31 and also moving another holder support 1471 in the -Z-direction as illustrated by an arrow AR32.

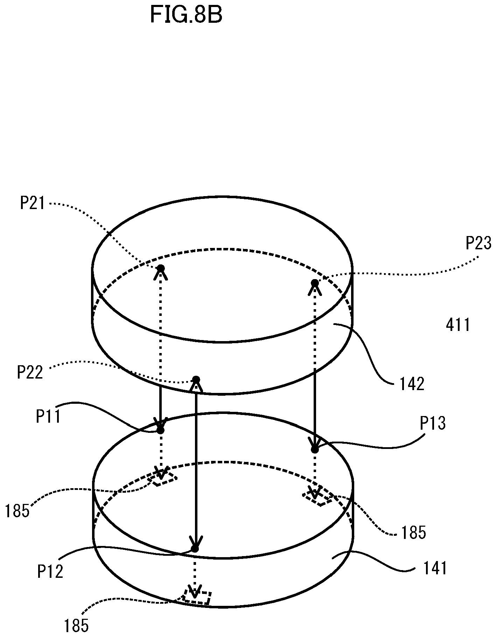

Returning to FIG. 5, the distance measurers 185 are, for example, laser range finders and measure distances between the stage 141 and the head 142 and distances between the substrate W1 held by the stage 141 and the substrate W2 held by the head 142 without coming into contact with the stage 141 and the head 142. Note that the distance measurers 185 may be distance measurers including, for example, laser interferometers. The distance measurers 185 are disposed at a plurality of locations in a peripheral portion of the base 183. Each of the distance measurers 185 measures distance between the stage 141 and the head 142 from a difference between reflected light reflected by a surface on the -Z-direction side of the head 142 and reflected light reflected by a surface on the +Z-direction side of the stage 141 when laser light is radiated from below the stage 141 toward the head 142. The distance measurers 185 measure distances between parts P11, P12, and P13 at three locations on the upper surface of the stage 141 and parts P21, P22, and P23 at three locations on the under surface of the head 402 that are opposed to the parts P 11, P12, and P13 in the Z-direction, respectively, as illustrated in FIG. 8B. In addition, the distance measurers 185 may, with the substrate W2 held by the head 142 or the substrate W1 held by the stage 141, measure distances between the substrate W1 or W2 and the stage 141 or the head 142 that does not hold the substrate W1 or W2. On this occasion, the distance measurers 185 radiate laser light from a side on which the stage 141 or the head 142 that does not hold the substrate W1 or W2 is located.

Returning to FIG. 5, the stage drivers 143 move the stage 141 in an XY-direction and rotate the stage 141 about the Z-axis. Each of the stage drivers 143 is inserted into a through-hole 120c that is formed in a peripheral wall of the chamber 120 from the outer side of the chamber 120, includes a pressing bar 1435 the tip portion of which comes into contact with a side surface of the base 183 and at the base end portion of which a flange is formed, and moves the stage 141 by pressing the base 183 by the pressing bar 1435. In addition, each of the stage drivers 143 is arranged on the outer side of the chamber 120 and includes a ball screw 1431, an actuator 1432 to drive the ball screw 1431 in the X-axis direction or the Y-axis direction, and a support member 1433 fixed to the chamber 120 and configured to support the actuator 1432. In this configuration, the ball screw 1431 comes into contact with the flange of the pressing bar 1435. Further, each of the stage drivers 143 includes a bellows 1434 for sealing a space between an outer peripheral portion of the through-hole 120c in a peripheral wall of the chamber 120 and a peripheral portion of the flange of the pressing bar 1435. Each of the air cylinders 186 is inserted into a through-hole 120c that is formed in a peripheral wall of the chamber 120 from the outer side of the chamber 120, includes a pressing bar 1865 the tip portion of which comes into contact with a side surface of the base 183 and at the base end portion of which a flange is formed, and biases the base 183 by the pressing bar 1865 in a direction in which the base 183 moves away from the air cylinder 186. Each of the air cylinders 186 includes a piston rod 1861 at the base end portion of which a piston (not illustrated) is disposed, a cylinder tube 1862 in which the piston is housed, and a support member 1863 fixed to the chamber 120 and configured to support the cylinder tube 1862 and has a structure in which pressure of air with which a space enclosed by the piston and the cylinder tube 1862 and located on the opposite side to the piston rod 1861 side is filled is applied to the piston rod 1861. In this configuration, a tip portion of the piston rod 1861 comes into contact with the flange of the pressing bar 1865. Further, each of the air cylinders 186 includes a bellows 1864 for sealing a space between an outer peripheral portion of the through-hole 120c in a peripheral wall of the chamber 120 and a peripheral portion of the flange of the pressing bar 1865.

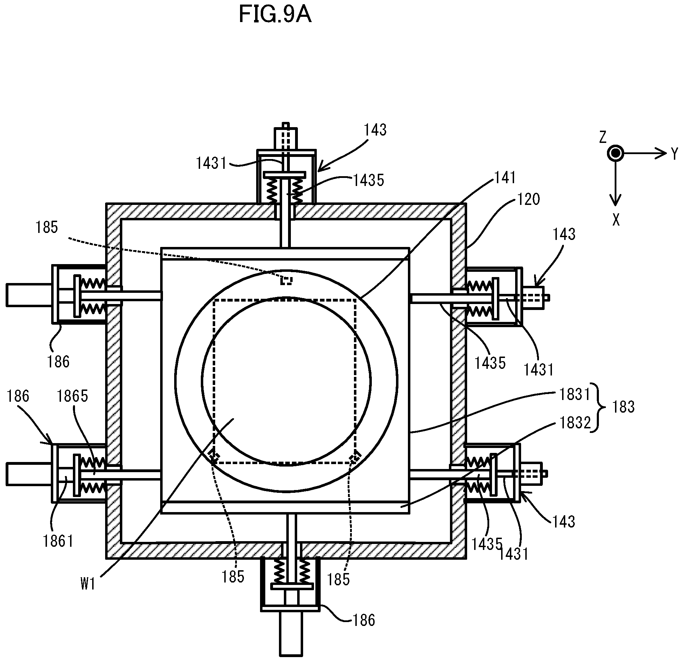

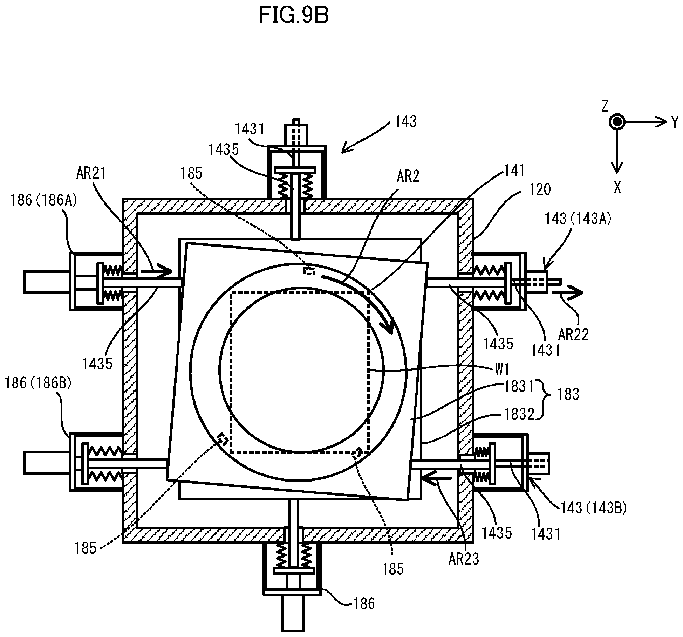

The stage drivers 143 are installed at three locations in the outer peripheral portion of the chamber 120 and the air cylinders 1861 are installed at three locations opposed to the stage drivers 143 in the outer peripheral portion of the chamber 120, as illustrated in, for example, FIG. 9A. It is assumed that, as illustrated in FIG. 9B, a stage driver 143B arranged on the +X-direction side and the +Y-direction side of the base 183 moves the pressing bar 1435 thereof to the inner side of the chamber 120 as illustrated by an arrow AR23 and a stage driver 143A arranged on the -X-direction side and the +Y-direction side of the base 183 also moves the pressing bar 1435 thereof to the outer side of the chamber 120 as illustrated by an arrow AR22. On this occasion, an air cylinder 186 arranged on the -X-direction side and the -Y-direction side of the base 183 biases the upper-side base 1831 to the +Y-direction side by the pressing bar 1865 thereof as illustrated by an arrow AR21. In this case, the air cylinder 186A pressing the stage 141 as illustrated by an arrow AR21 causes the stage 141 to rotate in the clockwise direction.

The position measurer 150 measures misalignment amounts between the substrate W1 and the substrate W2 in directions orthogonal to the vertical direction (an XY-direction and a rotational direction about the Z-axis). The position measurer 150 includes a first imager 151 and a second imager 152. The first imager 151 and the second imager 152 are arranged on the opposite side of the stage 141 to the side thereof on which the substrate W1 is held. In addition, each of the first imager 151 and the second imager 152 is fixed to top plate 114 by an imager support 115. Each of the first imager 151 and the second imager 152 includes an imaging element (not illustrated) and a coaxial illumination system (not illustrated). As light sources of the coaxial illumination systems, light sources that emit light (for example, infrared light) that is transmitted through the substrates W1 and W2, the stage 141, and the windows 121 disposed to the chamber 120 are used.

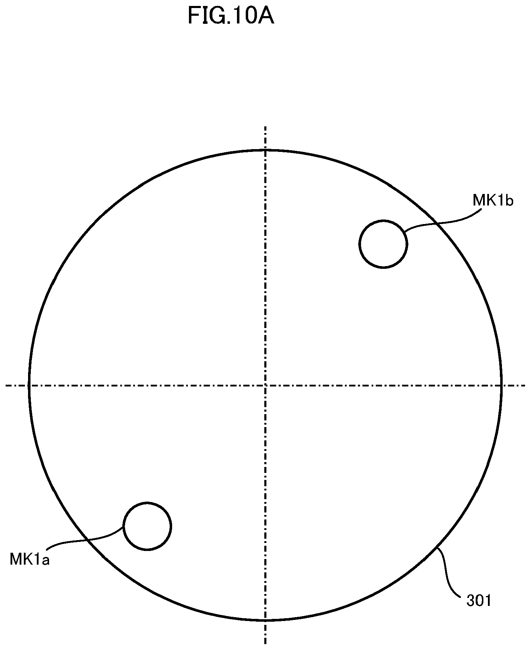

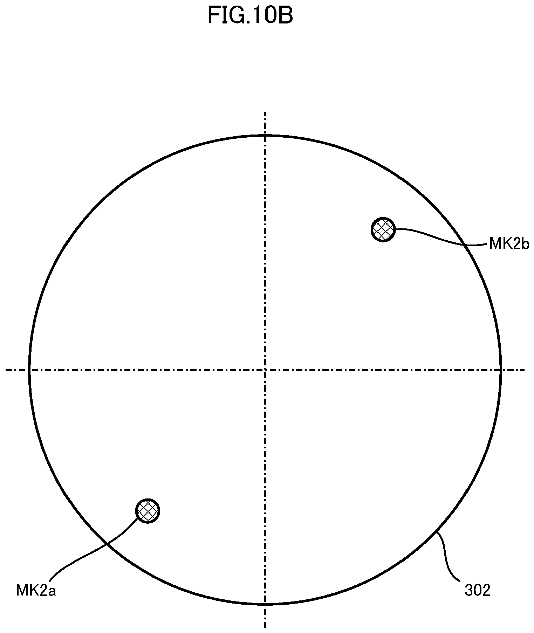

For example, as illustrated in FIGS. 10A and 10B, two alignment marks MK1a and MK1b are disposed on the substrate W1, and two alignment marks MK2a and MK2b are disposed on the substrate W2. The bonding device 1, while recognizing positions of the alignment marks MK1a, MK1b, MK2a, and MK2b, which are disposed on both substrates W1 and W2 by use of the position measurer 150, performs position alignment operation (alignment operation) of both substrates W1 and W2. More specifically, the bonding device 1 first, while recognizing the alignment marks MK1a, MK1b, MK2a, and MK2b, which are disposed on the substrates W1 and W2, by use of the position measurer 150, performs general alignment operation (rough alignment operation) of the substrates W1 and W2 and causes the two substrates W1 and W2 to face each other. Subsequently, the bonding device 1, while simultaneously recognizing the alignment marks MK1a, MK2a, MK1b, and MK2b, which are disposed on the two substrates W1 and W2, by use of the position measurer 500, performs finer alignment operation (fine alignment operation).

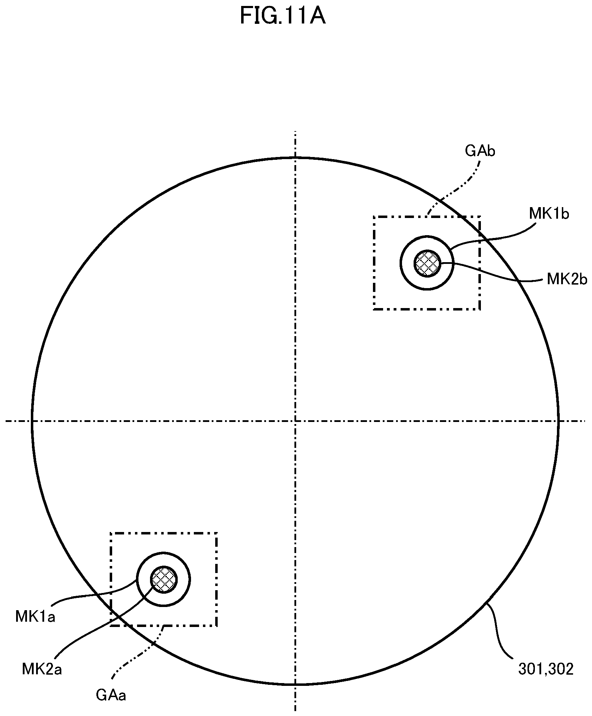

Returning to FIG. 5, light emitted from the light source of the coaxial illumination system of the first imager 151 proceeds upward and is transmitted through one of the windows 121, the stage 141, and portions or all of the substrates W1 and W2. The light that has been transmitted through portions or all of the substrates W1 and W2 is reflected by the alignment marks MK1a and MK2a on the substrates W1 and W2, proceeds downward, is transmitted through the stage 141 and the window 121, and is incident on the imaging element of the first imager 151. In addition, light emitted from the light source of the coaxial illumination system of the second imager 502 proceeds upward and is transmitted through the other window 121, the stage 141, and portions or all of the substrates W1 and W2. The light that has been transmitted through portions or all of the substrates W1 and W2 is reflected by the alignment marks MK1a and MK2a on the substrates W1 and W2, proceeds downward, is transmitted through the stage 141 and the window 121, and is incident on the imaging element of the second imager 152. In this way, the position measurer 150 acquires a captured image GAa including the alignment marks MK1a and MK2a on the two substrates W1 and W2 and a captured image GAb including the alignment marks MK1b and MK2b on the two substrates W1 and W2, as illustrated in FIG. 11A. Note that image capturing operation of the captured image GAa performed by the first imager 151 and image capturing operation of the captured image GAb performed by the second imager 152 are performed substantially at the same time. In addition, the position measurer 150 may have a configuration in which light sources are disposed in the head 142 and light from the light sources is fed into the first imager 151 and the second imager 152 from the head 142 side.

Returning to FIG. 5, the substrate heaters 1911 and 19122 are, for example, electrothermal heaters and are disposed in the stage 141 and the head 142, respectively. The substrate heaters 1911 and 1912 heat the substrates W1 and W2 by transmitting heat to the substrates W1 and W2 held by the stage 141 and the head 142, respectively. In addition, controlling the amount of heat generation by the substrate heaters 1911 and 1912 enables temperature of the substrates W1 and W2 and the bonding surfaces thereof to be controlled, respectively. In addition, the substrate heaters 1911 and 1912 are connected to heater drivers (not illustrated), and the heater drivers supply the substrate heaters 1911 and 1912 with current and thereby causes the substrate heaters 19111 and 1912 to generate heat, based on a control signal input from the controller 9 illustrated in FIG. 1.

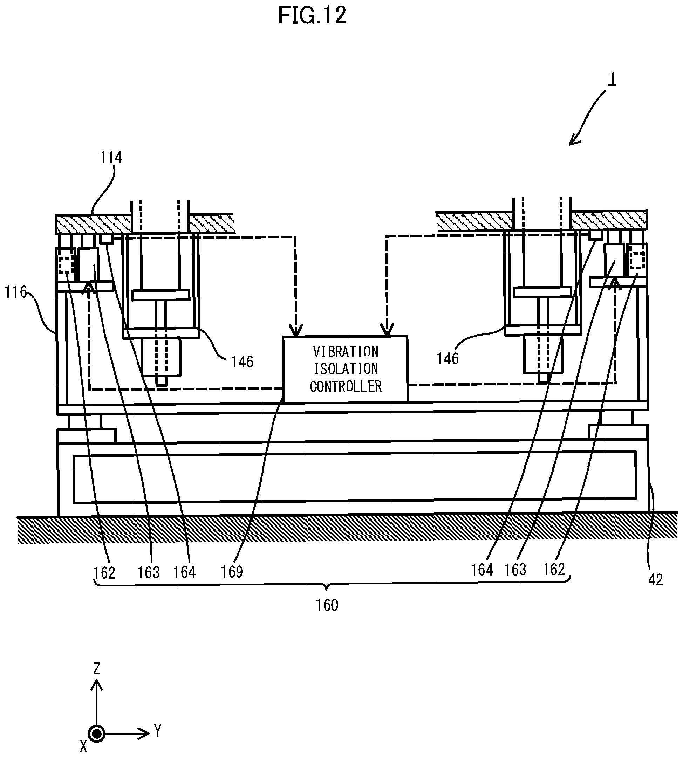

The vibration isolation unit 160 is a so-called active vibration isolation table and is interposed between the top plate 114 and the base 116. The vibration isolation unit 160 includes plate supports 162 that include anti-vibration mechanisms and are fixed to the base 116 and also support the top plate 114 on the +Z-direction side in a freely movable manner in the vertical direction and a horizontal direction, plate drivers 163, vibration detectors 164, and a vibration isolation controller 169 to control the plate drivers 163, as illustrated in FIG. 12. Each of the plate supports 162 includes an anti-vibration mechanism using, for example, an air spring or a coil spring and supports the top plate 114 in a freely movable manner in the vertical direction and a horizontal direction. Each of the vibration detectors 164 detects vibration transmitted to the top plate 114. Each of the plate drivers 163 and the plate drivers 423 is formed by a hydraulic actuator, an electromagnetic actuator, a pneumatic actuator, a piezo actuator, a linear actuator, or the like and applies, to the top plate 114, force acting in a direction in which the top plate 114 is caused to relatively move with respect to one of the plate supports 162. The vibration isolation controller 169 controls the plate drivers 163 in such a way as to reduce vibration transmitted to the top plate 114. Specifically, the vibration isolation controller 169 controls the plate drivers 163, based on vibration detected by the vibration detectors 164 in such a way that the top plate 114 moves in such a manner as to cancel the vibration.

In addition, the bonding device 1 includes the frame body 713 disposed in such a manner as to surround the gate 1211 on the outer side of the chamber 120 and a gate driver 1212 to drive the gate 1211, as illustrated in FIG. 2A. The frame body 713 is a first frame body that is arranged facing the frame body 712, and, when the sealing member 711 of the transportation device 84 is brought into the first state, the sealing member 711 is brought into a state of being in close contact with the entire circumference of the frame body 713. When the chamber 120 is opened to atmospheric air every time the substrate W1 or W2 is transported into the chamber 120 of the bonding device 1, increasing a degree of vacuum in the chamber 120 again after the substrate W 1 or W2 has been transported requires a certain amount of time. Thus, in the bonding system according to the present embodiment, it is required to, while maintaining the inside of the chamber 120 of the bonding device 1 at a high degree of vacuum, transport the substrates W1 and W2 from the load lock device 83 and the chamber 843 of the transportation device 84 to the chamber 120 of the bonding device 1. On the other hand, when the substrates W1 and W2 are bonded to each other in the bonding device 1, it is necessary to, by bringing the transportation device 84 and the bonding device 1 into a state of being separated from each other, reduce influence of vibration. Therefore, the bonding system according to the present embodiment has a configuration including the aforementioned frame bodies 712 and 713 and sealing member 711.

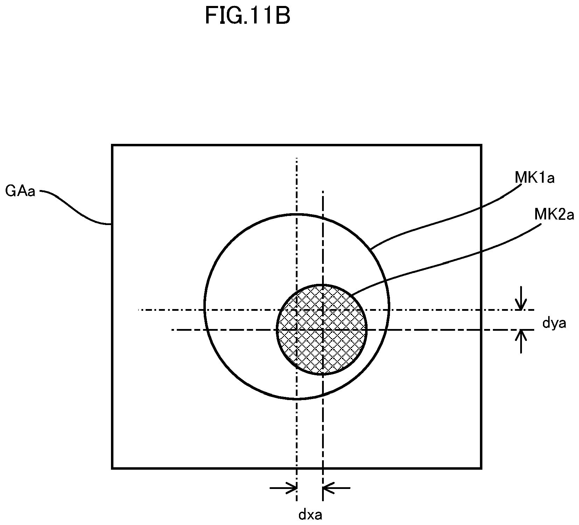

Returning to FIG. 1, the controller 9 is, for example, a control system including a personal computer and includes a central processing unit (CPU) and a memory. The memory stores programs that the CPU executes. The controller 9 converts measurement signals that are input from the pressure sensors 148 and the position measurer 150 to measurement information and acquires the measurement information. The controller 9 also converts captured image signals that are input from the first imager 151 and the second imager 152 to captured image information and acquires the captured image information. Further, the controller 9, by outputting a control signal to each of the support drivers 146, the stage drivers 143, the chuck drivers, the pressing drivers 1812 and 1822, and the heater drivers of the bonding device 1, controls operation of the foregoing components. The controller 9 calculates misalignment amounts dxa and dya between the pair of alignment marks MK1a and MK2a, which are disposed on the substrates W1 and W2, respectively, based on the captured image GAa acquired from the first imager 501, as illustrated in FIG. 11B. Note that FIG. 11B illustrates a state in which the pair of alignment marks MK1a and MK2a are misaligned from each other. Likewise, the controller 9 calculates misalignment amounts dxb and dyb between the other pair of alignment marks MK1b and MK2b, which are disposed on the substrates W1 and W2, respectively, based on the captured image GAb acquired from the second imager 502. Subsequently, based on the misalignment amounts dxa, dya, dxb, and dyb of the two pairs of alignment marks and a geometric relationship between the two pairs of marks, the controller 9 calculates relative misalignment amounts dx, dy, and dθ in the X-direction, the Y-direction, and the rotational direction about the Z-axis between the two substrates W1 and W2. The controller 9 causes the head 402 to move in the X-direction and the Y-direction or rotate about the Z-axis in such a way that the calculated misalignment amounts dx, dy, and dθ are reduced. In this way, the bonding device 1 performs the alignment operation that corrects the misalignment amounts dx, dy, and dθ in horizontal directions between the two substrates W1 and W2. In addition, the controller 9, by outputting a control signal to each of the activation treatment device 2, the transportation devices 82, 84, and 86, the cleaning device 3, the gate drivers 8332, 8322, 8532, 8522, 8622, 8422, and 1212, and the sealing driver 714, controls operation of the foregoing components.

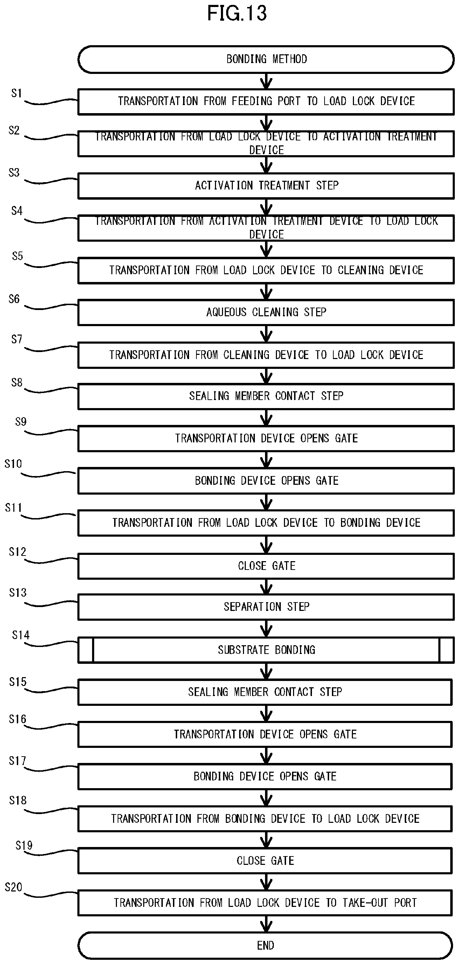

Next, with respect to the bonding system according to the present embodiment, a flow of operation from when the substrates W1 and W2 are input to the bonding system to when the substrates W1 and W2 have been bonded to each other and are taken out from the bonding system is described, referring to FIGS. 13 to 22. It is now assumed that the substrates W1 and W2 are arranged on the feeding ports 811 and 812 in advance, respectively. The substrates W1 and W2 are formed of one of, for example, a Si substrate, a glass substrate, an oxide substrate (for example, a silicon oxide (SiO₂) substrate or an alumina substrate (Al₂O₃)), and a nitride substrate (for example, silicon nitride (SiN) or aluminum nitride (AlN)). Note that at least one of the substrates W1 and W2 may be a substrate on the bonding surface of which a metal portion and an insulating film are exposed. Alternatively, at least one of the substrates W1 and W2 may be a substrate on the bonding surface of which an insulating film formed by depositing an oxide or a nitride is exposed. Herein, the description is made assuming that the substrate W1 is a glass substrate or an oxide substrate and the substrate W2 is a Si substrate or a nitride substrate. In addition, on the feeding port 811, for example, the substrate W2 to be held by the head 142 in the bonding device 1 is arranged, and, on the feeding port 812, for example, the substrate W1 to be placed on the stage 141 in the bonding device 1 is arranged.

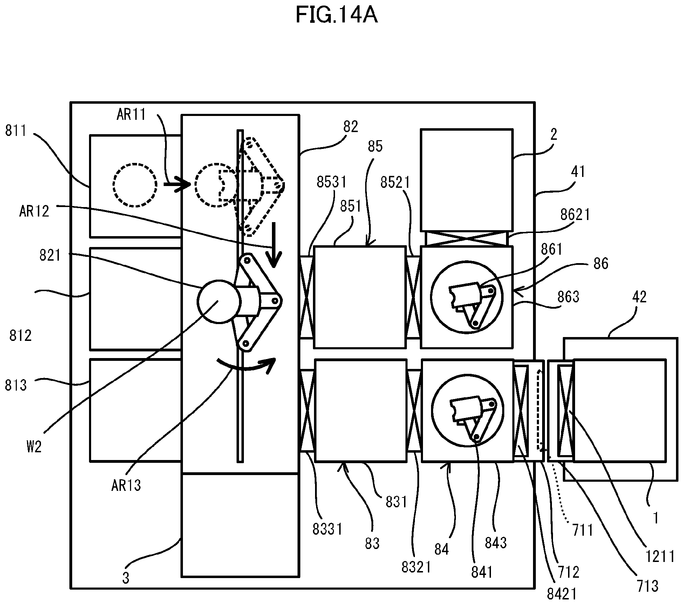

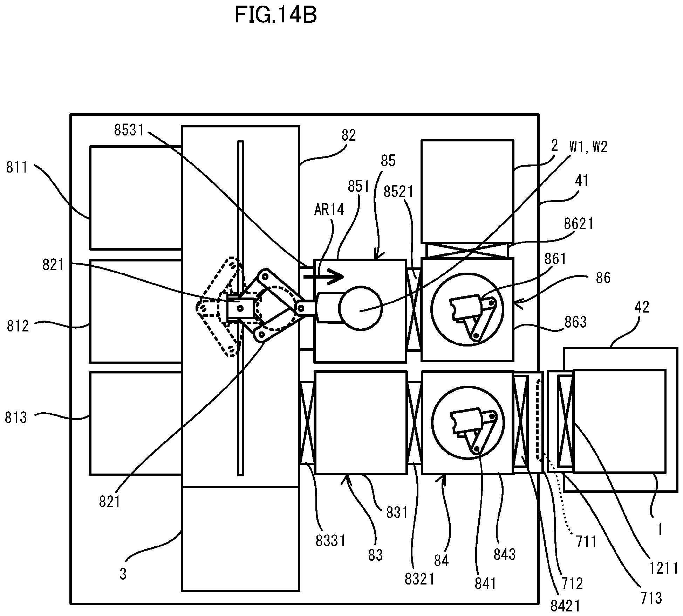

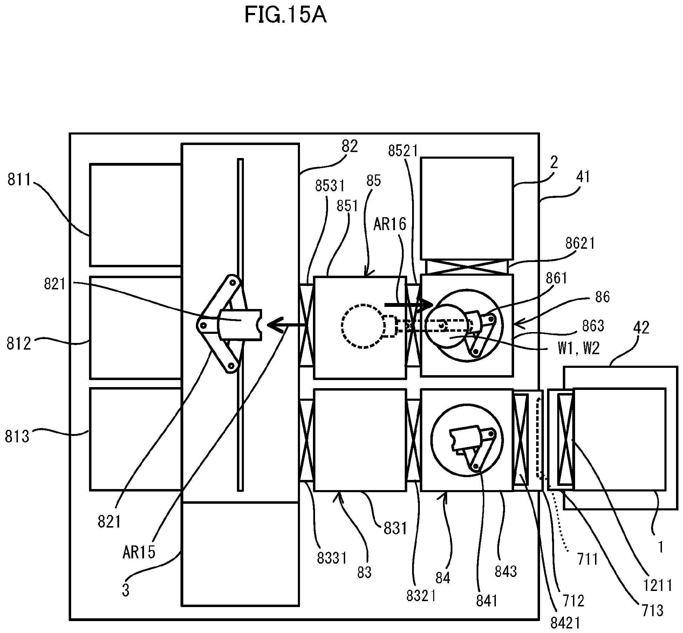

First, as illustrated in FIG. 13, the bonding system transports the substrates W1 and W2 from the feeding ports 811 and 812 to the load lock device 85, respectively (step S1). In this step, when the substrate W2 is arranged on the feeding port 811, the transportation robot 821 takes the substrate W2 out of the feeding port 811, as illustrated by an arrow AR11 in FIG. 14A. Then, the transportation robot 821, while holding the substrate W2, moves to a position on the transportation device 82 at which the transportation robot 821 carries the substrate W2 into the load lock device 85, as illustrated by an arrow AR12 in FIG. 14A. Note that, when the substrate W1 is arranged on the feeding port 812, after taking out the substrate W1 from the feeding port 812, the transportation robot 821 waits without moving while holding the substrate W1. Next, at the same time as the gate 8531 of the load lock device 85 is opened, the transportation robot 821 turns in such a way that the tip portion of the arm points to the load lock device 85 side, as illustrated by an arrow AR13 in FIG. 14A. Succeedingly, the transportation robot 821, by stretching the arm, inserts the tip portion of the arm into the chamber 851 of the load lock device 85, as illustrated by an arrow AR14 in FIG. 14B. Then, the substrate W1 or W2 is transferred from the tip portion of the arm to a stage disposed in the chamber 851 of the load lock device 85. Subsequently, when the transfer of the substrate W1 or W2 to the stage in the chamber 851 is finished, the transportation robot 821 contracts the arm, as illustrated by an arrow AR15 in FIG. 15A. Then, the load lock device 85, after closing the gate 8531, reduces pressure in the chamber 851.

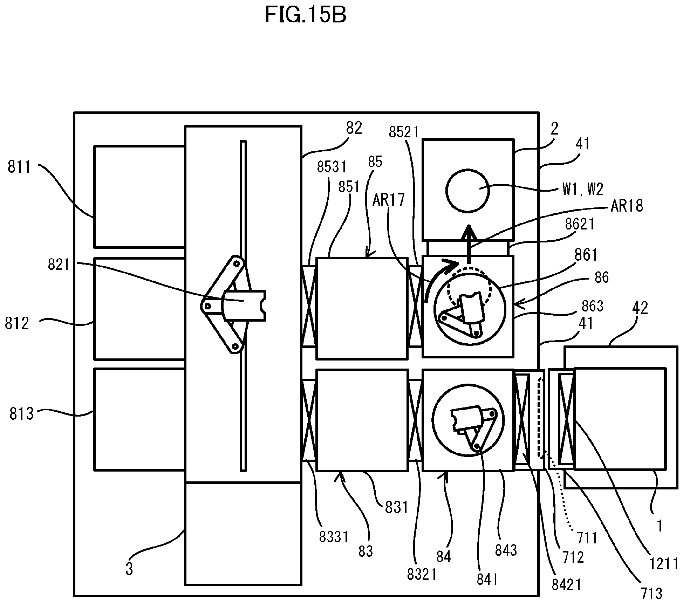

Next, as illustrated in FIG. 13, the bonding system transports the substrate W1 or W2 from the load lock device 85 to the activation treatment device 2 (step S2). In this step, as illustrated in FIG. 15A, after the load lock device 85 opens the gate 8521, the transportation robot 861, while pointing the tip portion of the arm to the load lock device 85 side, stretches the arm. When, in the chamber 851 of the load lock device 85, the substrate W1 or W2 is transferred from the stage to the tip portion of the arm, the transportation robot 861, by contracting the arm, takes the substrate W 1 or W2 out of the chamber 851, as illustrated by an arrow AR16. Subsequently, the load lock device 85 closes the gate 8521. Next, the transportation robot 861 turns in such a way that the tip portion of the arm points to the activation treatment device 2 side, as illustrated by an arrow AR17 in FIG. 15B. Then, the transportation device 86 opens the gate 8621. Succeedingly, the transportation robot 861, by stretching the arm, inserts the tip portion of the arm into the activation treatment device 2. Then, as illustrated by an arrow AR18, the substrate W1 or W2 is transferred from the tip portion of the arm of the transportation robot 861 to the stage 210 (see FIG. 4) in the activation treatment device 2. Subsequently, after the transportation robot 861 contracts the arm, the transportation device 86 closes the gate 8621.

Returning to FIG. 13, the activation treatment device 2, by subjecting at least one of the bonding surfaces to be bonded to each other of the respective ones of the substrates W1 and W2 to at least one of reactive ion etching using nitrogen gas and irradiation of nitrogen radicals, performs an activation treatment step of activating the bonding surface (step S3). In this step, the activation treatment device 2 uses a different processing sequence depending on the type of substrate to be processed in the activation treatment of the bonding surface. When the activation treatment device 2 subjects the bonding surface of the substrate W1, that is, a glass substrate or an oxide substrate, to the activation treatment, the activation treatment device 2 first feeds N₂ gas into the chamber 212 from the nitrogen gas storage 221A through the feeding pipe 223A by opening the feeding valve 222A illustrated in FIG. 2. Next, the activation treatment device 2, while suspending supply of high-frequency current from the high-frequency power source 216 to the induction coil 215, applies high-frequency bias to the substrate W1 or W2 placed on the stage 210 by the bias applier 217. Through this processing, the bonding surface of the substrate W1 is subjected to reactive ion etching (RIE) using N₂ gas. Succeedingly, the activation treatment device 2 starts supply of the high-frequency current from the high-frequency power source 216 to the induction coil 215 and thereby generates plasma with the N₂ gas. On this occasion, the activation treatment device 2 suspends application of the high-frequency bias to the substrate W1 by the bias applier 217. In this way, the bonding surface of the substrate W1 is irradiated with N₂ radicals.

On the other hand, when the activation treatment device 2 subjects the bonding surface of the substrate W2, that is, a Si substrate or a nitride substrate, to the activation treatment, the activation treatment device 2 first feeds O₂ gas into the chamber 212 from the oxygen gas storage 221B through the feeding pipe 223B by opening the feeding valve 222B. Next, the activation treatment device 2, while supply of high-frequency current from the high-frequency power source 216 to the induction coil 215 is suspended, applies a high-frequency bias to the substrate W2 placed on the stage 210 by the bias applier 217. Through this processing, the bonding surface of the substrate W2 is subjected to reactive ion etching (RIE) using O₂ gas. Succeedingly, the activation treatment device 2, by closing the feeding valve 622B and thereby suspending feeding of O₂ gas from the O₂ gas storage 621B into the chamber 612, exhausts the O₂ gas in the chamber 612. Subsequently, the activation treatment device 2 feeds N₂ gas into the chamber 212 from the nitrogen gas storage 221A through the feeding pipe 223A by opening the feeding valve 222A. Subsequently, the activation treatment device 2 starts supply of the high-frequency current from the high-frequency power source 216 to the induction coil 215 and thereby generates plasma with the N₂ gas. On this occasion, the activation treatment device 2 suspends application of the high-frequency bias to the substrate W2 by the bias applier 217. In this way, the bonding surface of the substrate W2 is irradiated with N₂ radicals.

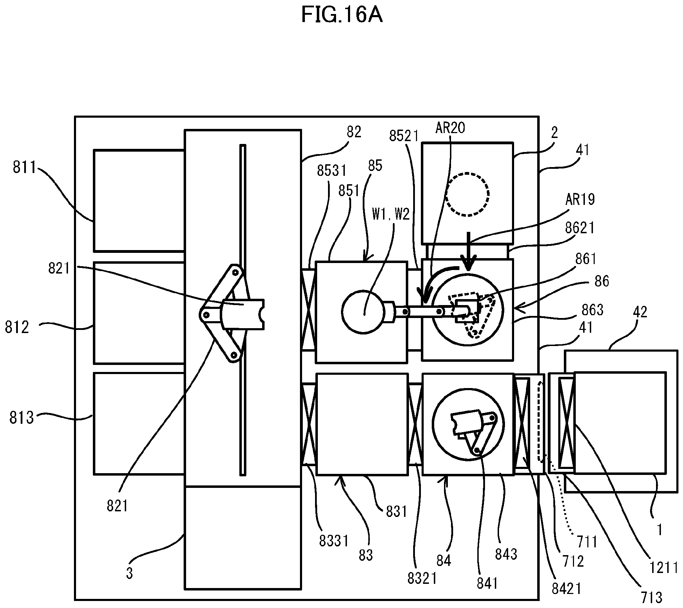

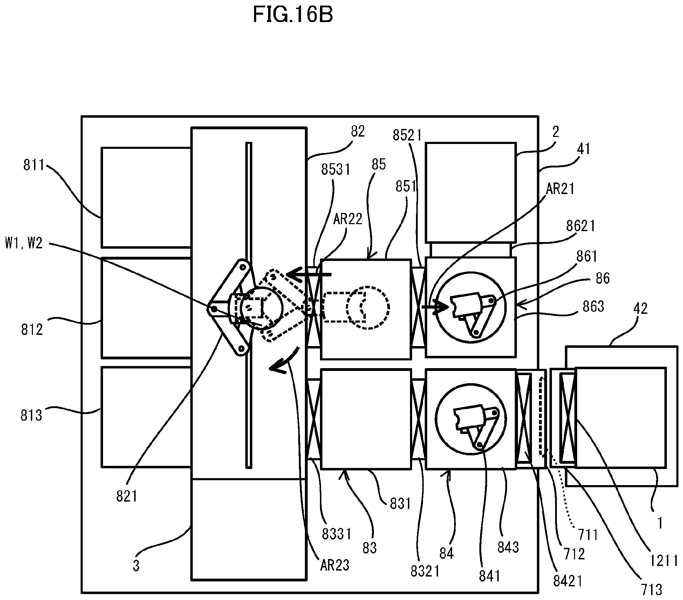

Returning to FIG. 13, subsequently, the transportation device 86 transports the substrate W1 or W2 from the activation treatment device to the load lock device 85 (step S4). In this step, when the transportation device 86 opens the gate 8621, the transportation robot 861, by stretching the arm, inserts the tip portion of the arm into the activation treatment device 2. Then, in the activation treatment device 2, the substrate W 1 or W2 is transferred from the stage 210 to the tip portion of the arm. Next, the transportation robot 861, by contracting the arm, takes the substrate W1 or W2 out of the activation treatment device 2, as illustrated by an arrow AR19 in FIG. 16A. Succeedingly, when the transportation robot 861 turns in such a way that the tip portion of the arm points to the load lock device 85 side as illustrated by an arrow AR20, the gate 8521 of the load lock device 85 is opened. Subsequently, the transportation robot 861, by stretching the arm, inserts the tip portion of the arm into the chamber 851 of the load lock device 85. Then, the substrate W1 or W2 is transferred from the tip portion of the arm to the stage in the chamber 851. Next, at the same time as the transportation robot 861 contracts the arm as illustrated by an arrow AR21 in FIG. 16B, the load lock device 85 closes the gate 8521.

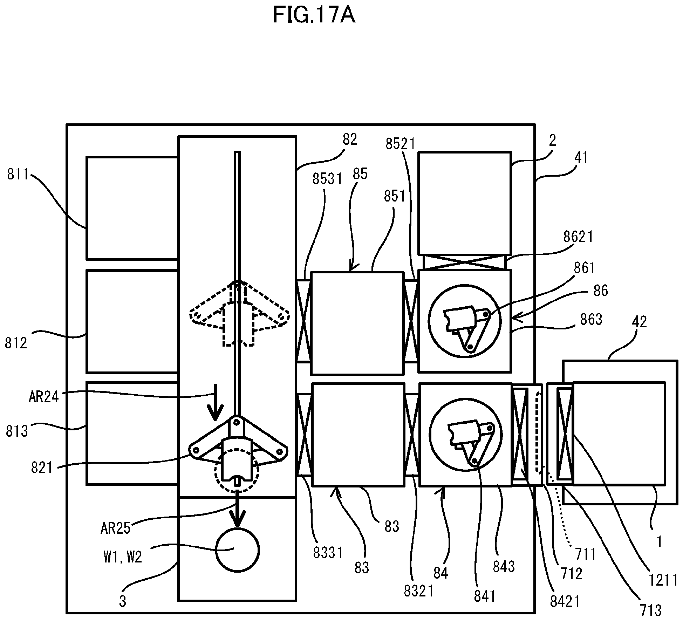

Next, the transportation device 82 transports the substrate W1 or W2 from the load lock device 85 to the cleaning device 3 (step S5). In this step, after the load lock device 85 opens the gate 8531, the transportation robot 821, while pointing the tip portion of the arm to the load lock device 85 side, stretches the arm and inserts the tip portion of the arm into the chamber 851 of the load lock device 85. Then, the substrate W1 or W2 is transferred from the stage in the chamber 851 to the tip portion of the arm of the transportation robot 821. Subsequently, after the transportation robot 821, by contracting the arm, takes the substrate W1 or W2 out of the load lock device 85 as illustrated by an arrow AR22 in FIG. 16B, the load lock device 85 closes the gate 8531. Next, the transportation robot 821 turns in such a way that the tip portion of the arm points to the cleaning device 3 side, as illustrated by an arrow AR23. Succeedingly, the transportation robot 821, while holding the substrate W1 or W2, moves to a position on the transportation device 82 at which the transportation robot 821 carries the substrate W1 or W2 into the cleaning device 3, as illustrated by an arrow AR24 in FIG. 17A. Succeedingly, the transportation robot 821, by stretching the arm, inserts the tip portion of the arm into the cleaning device 3. Then, as illustrated by an arrow AR25, the substrate W1 or W2 is transferred from the tip portion of the arm of the transportation robot 821 to the stage in the cleaning device 3.

Returning to FIG. 13, succeedingly, the cleaning device 3 performs an aqueous cleaning step of cleaning the bonding surface of the substrate W1 or W2 while spraying water on the bonding surface of the substrate W1 or W2 (step S6). In this step, the cleaning device 3, while spraying water to which ultrasonic waves are applied on the bonding surface of the substrate W1 or W2 from the cleaning head, causes the stage on which the substrate W1 or W2 is placed to scan in XY directions and cleans the entire bonding surface of the substrate W1 or W2. Through this processing, foreign objects having adhered to the bonding surface of the substrate W1 or W2 are removed. Succeedingly, the cleaning device 3 suspends the discharge of water by the cleaning head and subsequently, by spin-drying the substrate by rotating the stage, finishes the cleaning treatment.

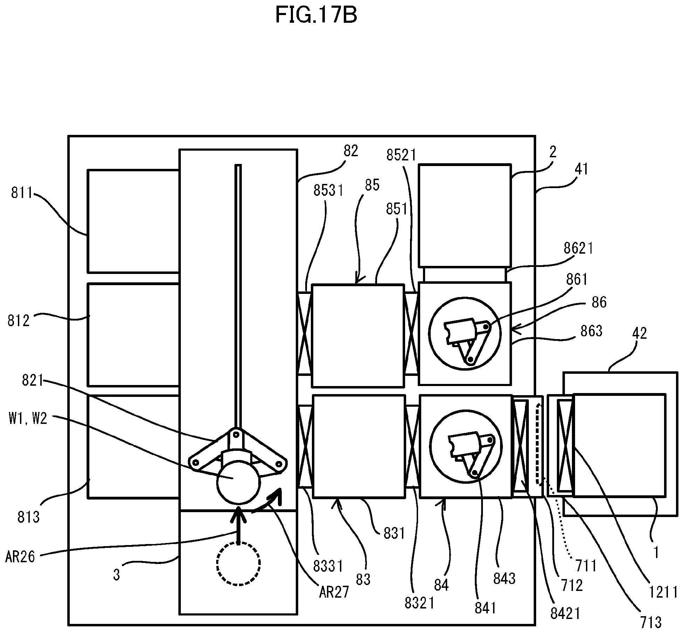

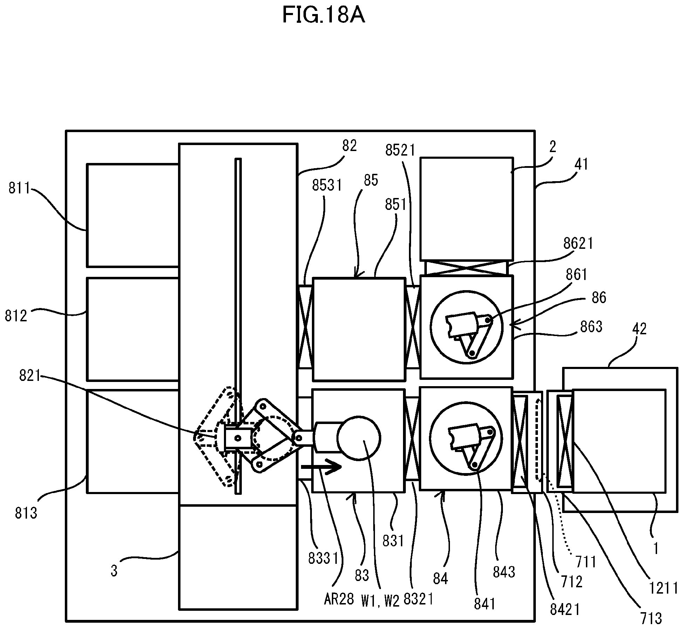

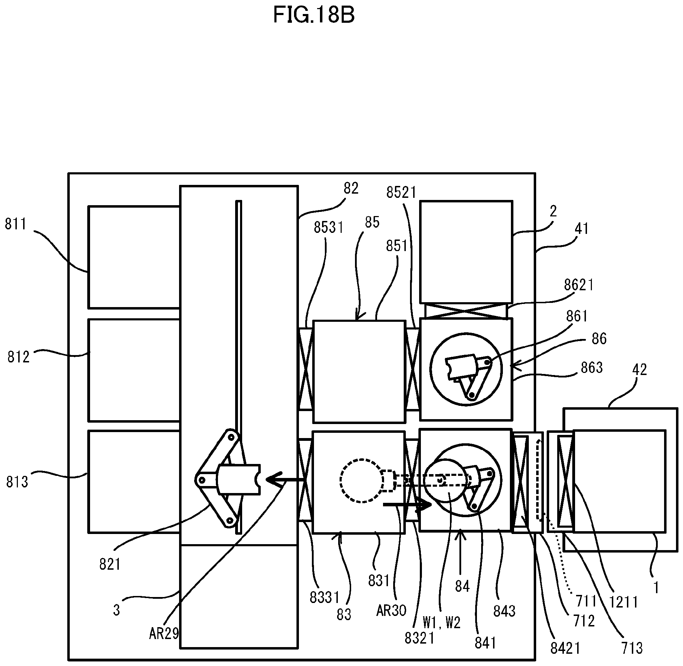

Subsequently, the transportation device 82 transports the substrate W1 or W2 from the cleaning device 3 to the load lock device 83 (step S7). In this step, the transportation robot 821, by stretching the arm, inserts the tip portion of the arm into the cleaning device 3 and transfers the substrate W1 or W2 from the stage to the tip portion of the arm. Next, the transportation robot 821, by contracting the arm, takes the substrate W1 or W2 out of the cleaning device 3, as illustrated by an arrow AR26 in FIG. 17B. Succeedingly, the transportation robot 821, while holding the substrate W1 or W2, turns in such a way that the tip portion of the arm points to the load lock device 83 side, as illustrated by an arrow AR27. Subsequently, when the load lock device 83 opens the gate 8331, the transportation robot 821, by stretching the arm, inserts the tip portion of the arm into the chamber 831 of the load lock device 83, as illustrated by an arrow AR29 in FIG. 18A. Then, the substrate W1 or W2 is transferred from the tip portion of the arm to the stage in the chamber 831. Next, when the transfer of the substrate W1 or W2 to the stage in the chamber 831 is finished, the transportation robot 821 contracts the arm, as illustrated by an arrow AR30 in FIG. 18B. Then, the load lock device 83 closes the gate 8331.

Returning to FIG. 13, next, the sealing driver 714 of the transportation device 84 performs a sealing member contact step of, by filling the filling space S71 of the sealing member 711 with gas, bringing the sealing member 711 from the second state illustrated in FIG. 2A to the first state illustrated in FIG. 2B (step S8). Returning to FIG. 13, succeedingly, the transportation device 84 opens the gate 8421 (step S9). Through this processing, air existing in the space S72 between the frame body 713 and the frame body 712 illustrated in FIG. 2B is discharged to the outside of the space S72 by the vacuum pump for exhausting gas existing in the chamber 843 of the transportation device 84. Subsequently, as illustrated in FIG. 9, the bonding device 1 opens the gate 1211 (step S10).

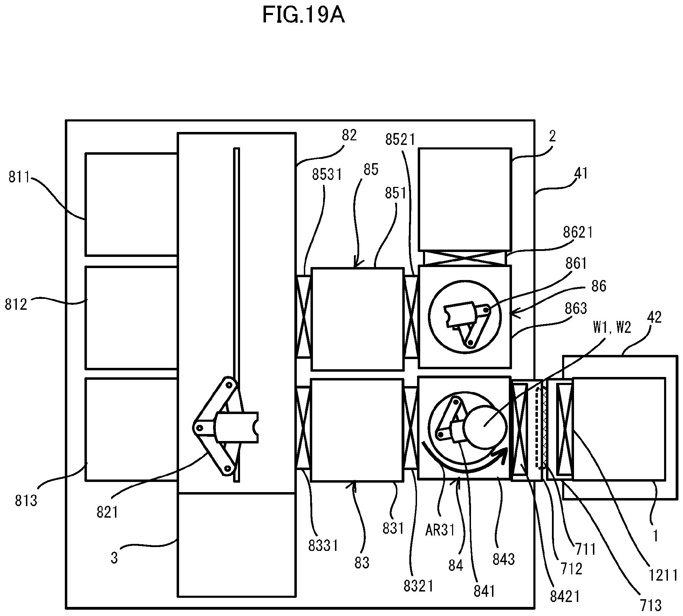

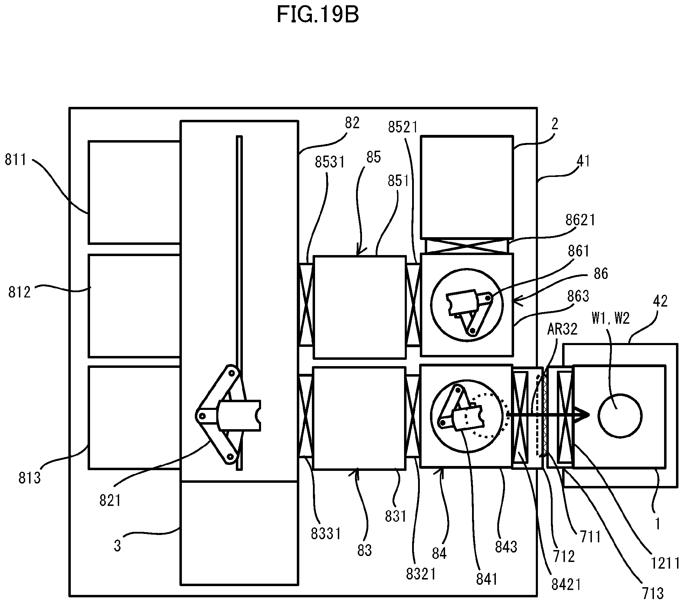

Next, the transportation device 84 transports the substrate W1 or W2 from the load lock device 83 to the bonding device 1 (step S11). In this step, after the load lock device 83 opens the gate 8321, the transportation robot 841, while pointing the tip portion of the arm to the load lock device 83 side, stretches the arm and inserts the tip portion of the arm into the chamber 831 of the load lock device 83. When, in the chamber 831 of the load lock device 83, the substrate W1 or W2 is transferred from the stage to the tip portion of the arm, the transportation robot 841, by contracting the arm, takes the substrate W1 or W2 out of the load lock device 83, as illustrated by an arrow AR31 in FIG. 18B. Next, the load lock device 83 closes the gate 8321. Succeedingly, the transportation robot 841 turns in such a way that the tip portion of the arm points to the bonding device 1 side, as illustrated by an arrow AR31 in FIG. 19A. On this occasion, in the case where the transportation robot 841 takes out of the load lock device 83 the substrate W2 that is to be supported by the head 142 in the bonding device 1, the transportation robot 841, at the same time as turning, reverses the tip portion of the arm. Subsequently, the transportation robot 841, by stretching the arm, inserts the tip portion of the arm into bonding device 1. Then, as illustrated by an arrow AR32 in FIG. 19B, the substrate W2 is transferred from the tip portion of the arm of the transportation robot 841 to the head 142 in the bonding device 1, or the substrate W1 is transferred from the tip portion of the arm of the transportation robot 841 to the stage 141 in the bonding device 1. On this occasion, the substrate bonding device 1 performs a substrate holding step of causing the stage 141 to hold the substrate W1 and also causing the head 142 to hold the substrate W2 while the bonding surfaces of the substrates W1 and W2 face each other. Specifically, the controller 9 drives the electrostatic chuck 1411 of the stage 141 while, for example, the substrate W1 is placed on the stage 401, and thereby causes the stage 141 to hold the substrate W1. In addition, the controller 9 drives the electrostatic chuck 1421 of the head 142 while the head 142 is brought into contact with the opposite side to the bonding surface side of the substrate W2 arranged vertically directly below the head 142 by, for example, a transportation robot (not illustrated), and thereby causes the head 142 to hold the substrate W2. Then, the transportation robot 841 contracts the arm.

Returning to FIG. 13, succeedingly, the bonding device 1 closes the gate 1211 and the transportation device 84 closes the gate 8421 (step S12). Subsequently, the sealing driver 714 of the transportation device 84 performs a separation step of, by discharging gas in the filling space S71 of the sealing member 711 and thereby contracting the sealing member 711, bringing the sealing member into the second state in which the sealing member 711 is separated from the frame body 713 of the bonding device 1 (step S13).

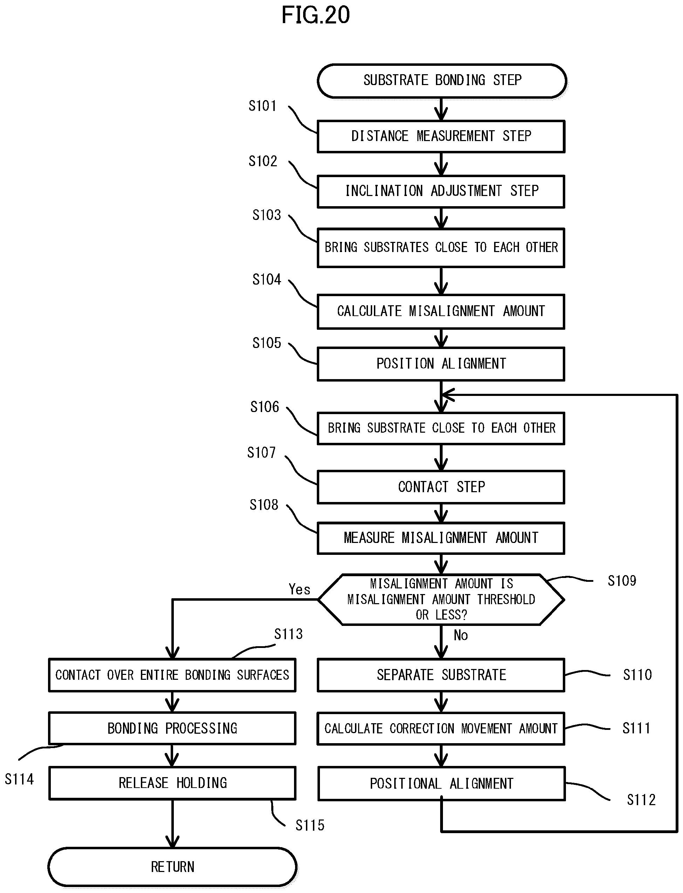

Subsequently, the bonding device 1 performs a substrate bonding step of bonding the substrates W1 and W2 to each other (step S14). The substrate bonding step is described in detail below, referring to FIG. 20. Note that, in FIG. 20, it is assumed that the bonding device 1 has already stored measurement results of thicknesses of the substrates W1 and W2 in the memory of the controller 9. First, the bonding device 1 performs a distance measurement step of measuring distances between the stage 141 and the head 142 at three locations on the stage 141 and three locations on the head 142 by the distance measurers 185 (step S101).

Next, the bonding device 1 performs an inclination adjustment step of adjusting inclination of the head 142 with respect to the stage 141, based on distances between the stage 141 and the head 142 at three locations on the stage 141 and three locations on the head 142 (step S102). In this step, the bonding device 1 performs parallelism adjustment to, by each of the three support drivers 146 individually moving one of the three holder supports 1471 in the Z-axis direction, adjust inclination of the head 142 with respect to the stage 141 in such a way that a placement surface of the head 142 for the substrate W2 and a placement surface of the stage 141 for the substrate W2 become parallel with each other. Note that the bonding device 1 do not necessarily have to perform the inclination adjustment of the head 142 with respect to the stage 141 every time the processing for bonding the substrates W1 and W2 to each other is performed. For example, the bonding device 1 may be configured to perform the inclination adjustment of the head 142 with respect to the stage 141 every time the processing for bonding the substrates W1 and W2 to each other is performed a preset number of times. Alternatively, the bonding device 1 may be configured to, after performing the inclination adjustment of the head 142 with respect to the stage 141 at the time of initial setting, maintain the locking mechanisms 149 in the locked state. In this step, adjustment in the thickness direction of the substrates W1 and W2 is performed by the support drivers 146 moving the holder supports 1471 at the same time. Maintaining the locking mechanisms 149 in the locked state enables the support drivers 146 to provide the holder supports 1471 with driving force in the -Z-direction and thereby press the substrate W2 against the substrate W2 and pressing force when the substrates W1 and W2 are pressed against each other to be increased. This configuration enables the bonding device 1 to cope with a case of bonding of the substrates W1 and W2 to each other by applying surface pressure.

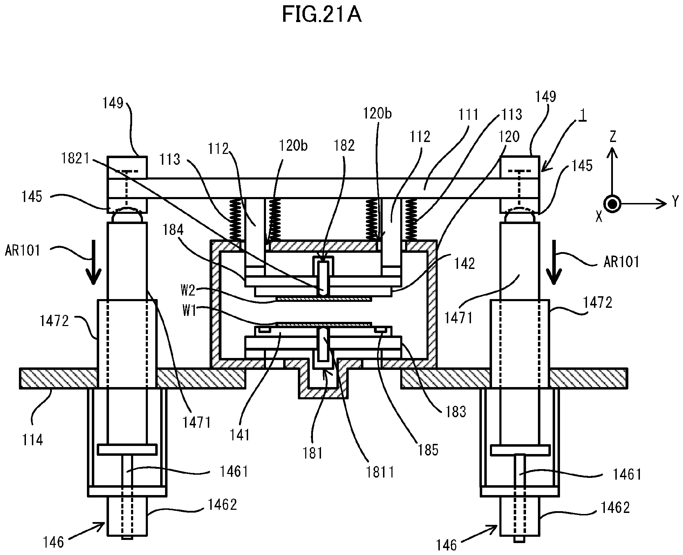

Succeedingly, the bonding device 1 calculates a distance between the bonding surface of the substrate W1 and the bonding surface of the substrate W2, based on the distance between the upper surface of the stage 141 and the under surface of the head 142 while the substrates W1 and W2 are not held by the stage 141 and the head 142, respectively, and the thicknesses of the substrates W1 and W2. Then, the bonding device 1 moves the head 142 vertically downward based on the calculated distance and thereby brings the substrates W1 and W2 close to each other (step S103). On this occasion, the bonding device 1 brings the head 142 close to the stage 141 by moving the three holder supports 1471 vertically downward, that is, in the -Z-direction, at the same time, as illustrated by arrows AR101 in FIG. 21A.

Returning to FIG. 20, subsequently, the bonding device 1 calculates misalignment amounts of the substrate W1 with respect to the substrate W2 while the substrates W1 and W2 are separated from each other (step S104). In this step, the controller 9 first acquires captured images GAa and GAb (see FIG. 11A) of the two substrates W1 and W2 in the non-contact state from the first imager 501 and the second imager 502 in the position measurer 500. The controller 9 calculates each of misalignment amounts dx, dy, and dθ in the X-direction, the Y-direction, and the rotational direction about the Z-axis between the two substrates W1 and W2, based on the two captured images GAa and GAb, as described before.

Next, the bonding device 1 performs position alignment by relatively moving the substrate W2 with respect to the substrate W1 in such a way as to correct the calculated misalignment amounts dx, dy, and dθ (step S105). In this step, the bonding device 1 moves the stage 141 in the X-direction, the Y-direction, and the rotational direction about the Z-axis in such a way as to reduce the misalignment amounts dx, dy, and dθ.

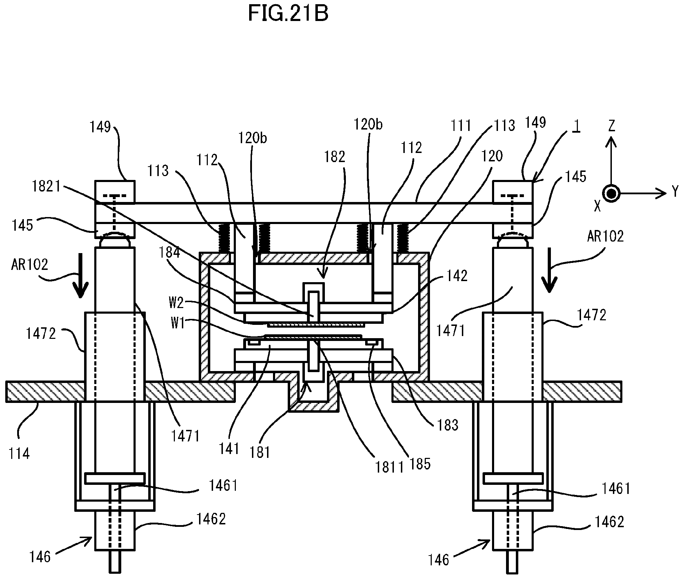

Succeedingly, the bonding device 1, by bringing the head 142 closer to the stage 141, brings the two substrates W1 and W2 close to each other (step S106). In this step, the bonding device 1 arranges the head 142 at a position at which a gap between the substrates W1 and W2 becomes an optimal gap to bring central portions of the substrates W1 and W2 into contact with each other while the substrates W1 and W2 are bent. While the substrates W1 and W2 are in this state, the bonding device 1 brings the substrates W1 and W2 into a state in which the peripheral portions of the substrates W1 and W2 are separated from each other by approximately 50 µm. On this occasion, the bonding device 1 brings the head 142 close to the stage 141 by moving the three holder supports 1471 in the -Z-direction at the same time, as illustrated by arrows AR102 in FIG. 21B.

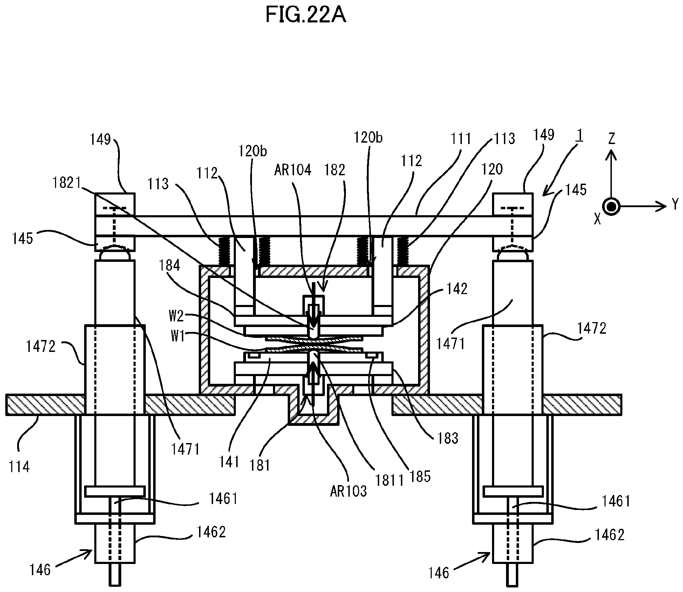

Returning to FIG. 20, subsequently, the bonding device 1 performs a contact step of bringing the central portion of the substrate W1 and the central portion of the substrate W2 into contact with each other by causing the substrates W1 and W2 to bend while the substrates W1 and W2 are separated from each other (step S107). The bonding device 1 causes the W 1 to bend in such a manner that the central portion of the substrate W1 protrudes toward the substrate W2 with respect to a peripheral portion of the substrate W1, as illustrated in, for example, FIG. 22A. On this occasion, the bonding device 1 causes the pressing rod 1811 to press the central portion of the substrate W1 toward the substrate W2 as illustrated by an arrow AR103 while causing the electrostatic chuck 1411 to hold the peripheral portion of the substrate W1 by causing the chuck driver to apply voltage to the electrostatic chuck 1411. This processing causes the substrate W1 to bend in such a way that a central portion W1c of the substrate W1 protrudes toward the substrate W2. In addition, the bonding device 1 causes the substrate W2 to bend in such a manner that the central portion of the substrate W2 protrudes toward the substrate W1 with respect to a peripheral portion of the substrate W2. On this occasion, the bonding device 1 causes the pressing rod 1821 to press the central portion of the substrate W2 toward the substrate W1 as illustrated by an arrow AR104 while causing the electrostatic chuck 1421 to hold the peripheral portion of the substrate W2 by causing the chuck driver to apply voltage to the electrostatic chuck 1421. This processing causes the substrate W2 to bend in such a way that the central portion of the substrate W2 protrudes toward the substrate W1. In addition, while the substrates W1 and W2 have distance between the peripheral portions thereof kept constant, a contact area between the substrates W1 and W2 expands from the central portions toward the peripheral portions of the substrates W1 and W2 by intermolecular force (the van der Waals force) generated between the substrates W1 and W2 or bonding force due to water or OH groups existing on the bonding surfaces of the substrates W1 and W2 with the central portions to which point pressure is applied by the pressing mechanisms 181 and 182 as a starting point.

Next, the bonding device 1 measures misalignment amounts of the substrate W2 with respect to the substrate W1 while the bonding surface of the substrate W1 and the bonding surface of the substrate W2 are in contact with each other (step S108). On this occasion, the bonding device 1 measures the misalignment amounts between the substrates W1 and W2 while movement of the substrate W2 with respect to the substrate W1 is restricted by the contact area between the substrate W1 and the substrate W2 expanding. Succeedingly, the bonding device 1 determines whether or not all of the calculated misalignment amounts dx, dy, and dθ are less than or equal to preset misalignment amount threshold values dxth, dyth, and dθth, respectively (step S109).

In this step, it is assumed that, by the bonding device 1, one of the calculated misalignment amounts dx, dy, and dθ is determined to be greater than a corresponding one of the preset misalignment amount threshold values dxth, dyth, and dθth (step S109: No). In this case, the bonding device 1 separates the substrate W2 from the substrate W1 by causing the head 142 to ascend (step S110). On this occasion, the bonding device 1, while causing the head 142 to ascend and thereby widening distance between the substrates W1 and W2, causes the pressing rod 1811 to move in a direction in which the pressing rod 1811 is caused to retract into the stage 141 and also causes the pressing rod 1821 to move in a direction in which the pressing rod 1821 is caused to retract into the head 142. In this processing, the bonding device 1 controls ascent of the head 142 in such a way that tensile pressure on the substrate W2 when the substrate W2 is peeled from the substrate W1 is constant. This configuration causes the substrate W2 to be separated from the substrate W1 and the contact state between the substrate W1 and the substrate W2 to be released.

Succeedingly, the bonding device 1 calculates correction movement amounts of the substrates W1 and W2 required to decrease all of the calculated misalignment amounts dx, dy, and dθ to the misalignment amount threshold values dxth, dyth, and dθth or less, respectively (step S111). In this step, the controller 9 calculates correction movement amounts that cause the substrates W1 and W2 to move by movement amounts equivalent to differences between the misalignment amounts dx, dy, and dθ between the substrate W1 and the substrate W2 while the substrate W2 is in contact with the substrate W1 and misalignment amounts between the substrate W1 and the substrate W2 while the substrate W2 is not in contact with the substrate W1. Aligning the substrates W1 and W2 with the positions thereof offset from each other by the correction movement amounts enables misalignment between the substrates W1 and W2 to be eliminated if similar misalignment caused by the substrates W1 and W2 coming into contact with each other occurs when the substrates W1 and W2 come into contact with each other again.

Subsequently, the bonding device 1 performs position alignment in such a way as to correct the relative misalignment amounts dx, dy, and dθ between the two substrates W1 and W2 while the two substrates W1 and W2 are not in contact with each other (step S112). In this processing, the bonding device 1 moves the stage 141 in the X-direction, the Y-direction, and the rotational direction about the Z-axis by the correction movement amounts calculated in step S111. In this way, the bonding device 1 adjusts the relative position of the substrate W2 with respect to the substrate W1 in such a way that the misalignment amounts dx, dy, and dθ is reduced while the substrates W1 and W2 are separated from each other. Subsequently, the bonding device 1 performs the processing in step S106 again.

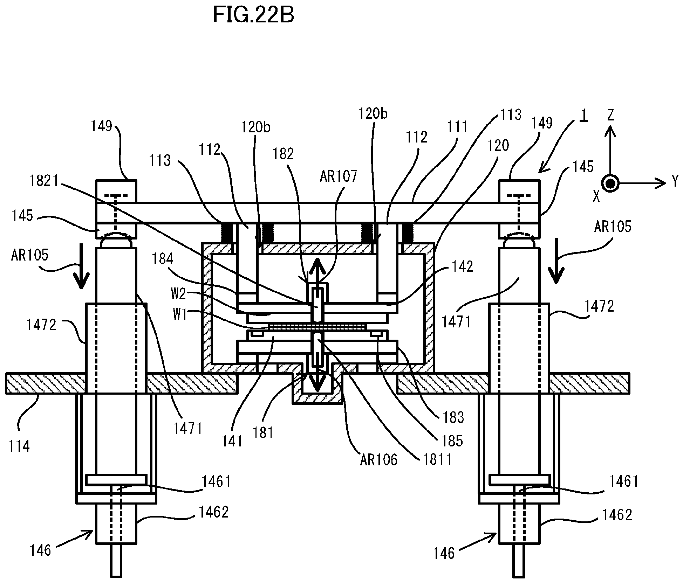

On the other hand, it is assumed that, by the bonding device 1, all of the calculated misalignment amounts dx, dy, and dθ are determined to be less than or equal to the preset misalignment amount threshold values dxth, dyth, and dθth, respectively (step S109: Yes). In this case, the bonding device 1 further enlarges the contact area between the substrates W1 and W2 from the central portions toward the peripheral portions of the substrates W1 and W2 and brings the substrates W1 and W2 into contact with each other over the entire bonding surfaces (step S1 13). In this processing, the bonding device 1 reduces distance between the peripheral portions of the substrates W1 and W2 by causing the pressing rod 1811 of the pressing mechanism 181 to move in a direction in which the pressing rod 1811 is caused to retract into the stage 141 as illustrated by an arrow AR 106 in FIG. 22B and causing the pressing rod 1821 of the pressing mechanism 182 to move in a direction in which the pressing rod 1821 is caused to retract into the head 142 as illustrated by an arrow AR107 and, at the same time, causing the head 142 to move in a direction in which the head 142 comes close to the stage 141 as illustrated by arrows AR105. In this way, the bonding device 1 brings the peripheral portion of the substrate W1 into contact with the peripheral portion of the substrate W2 and thereby brings the bonding surfaces of the substrates W1 and W2 into contact with each other over the entire bonding surfaces.

Returning to FIG. 20, next, the bonding device 1 performs a bonding step of bonding the substrates W1 and W2 to each other by pressing the peripheral portions W1s and W2s of the substrates W1 and W2 against each other through pressing only the peripheral portion W1s of the substrate W1 against the peripheral portion W2s of the substrate W2 while the substrates W1 and W2 are in contact with each other over the entire bonding surfaces (step S114). Succeedingly, the bonding device 1 releases holding of the substrate W2 by the head 142 by suspending operation of the electrostatic chuck 1421 of the head 142 (step S115). Subsequently, the bonding device 1 separates the head 142 from the substrate W2 by causing the head 142 to ascend.

Returning to FIG. 13, after the aforementioned substrate bonding step (step S14), the sealing driver 714 of the transportation device 84 performs a sealing member contact step of bringing the sealing member 711 from the aforementioned second state to the aforementioned first state again (step S15). Succeedingly, after the transportation device 84 opens the gate 8421 (step S16), the bonding device 1 opens the gate 1211 (step S17). Subsequently, the transportation device 84 transports the substrates W1 and W2 bonded to each other from the bonding device 1 to the load lock device 83 (step S18). In this step, the transportation robot 841, by stretching the arm, inserts the tip portion of the arm into bonding device 1. Then, the substrates W1 and W2 that are bonded to each other are transferred from the stage 141 or the head 142 in the bonding device 1 to the tip portion of the arm of the transportation robot 841. Next, the transportation robot 841, by contracting the arm, takes the substrates W1 and W2 bonded to each other out of the bonding device 1. Succeedingly, the transportation robot 841 turns in such a way that the tip portion of the arm points to the load lock device 83 side. Subsequently, the transportation robot 841, by stretching the arm while pointing the tip portion of the arm to the load lock device 83 side, inserts the tip portion of the arm into the chamber 831 of the load lock device 83. When, in the chamber 831, the substrates W1 and W2 bonded to each other are transferred from the tip portion of the arm to the stage, the transportation robot 841 contracts the arm.

Succeedingly, the bonding device 1 closes the gate 1211 and the transportation device 84 closes the gate 8421 (step S19). On this occasion, the sealing driver 714 of the transportation device 84 performs a separation step of, by appropriately contracting the sealing member 711, bringing the sealing member into the second state in which the sealing member 711 is separated from the frame body 713 of the bonding device 1.

Succeedingly, the transportation device 82 transports the substrates W1 and W2 bonded to each other from the load lock device 83 to the take-out port 813 (step S20). In this step, when the load lock device 83, after opening the inside of the chamber 831 to atmospheric air, opens the gate 8331, the transportation robot 821, while pointing the tip portion of the arm to the load lock device 83 side, stretches the arm and inserts the tip portion of the arm into the chamber 831. Then, the substrates W1 and W2 bonded to each other are transferred from the stage in the chamber 831 to the tip portion of the arm of the transportation robot 821. Subsequently, after the transportation robot 821, by contracting the arm, takes the substrates W1 and W2 bonded to each other out of the load lock device 83, the load lock device 83 closes the gate 8331. Succeedingly, the transportation robot 821 turns in such a way that the tip portion of the arm points to the opposite side to the load lock device 83 side. Subsequently, the transportation robot 821, while holding the substrates W1 and W2 bonded to each other, stretches the arm and thereby inserts the tip portion of the arm into the take-out port 813 and arranges the substrates W1 and W2 bonded to each other on the take-out port 813.

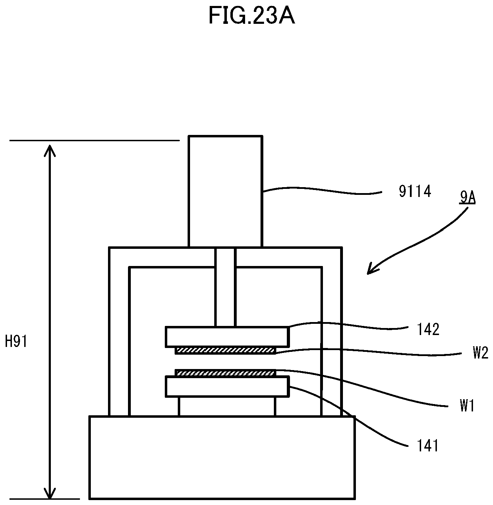

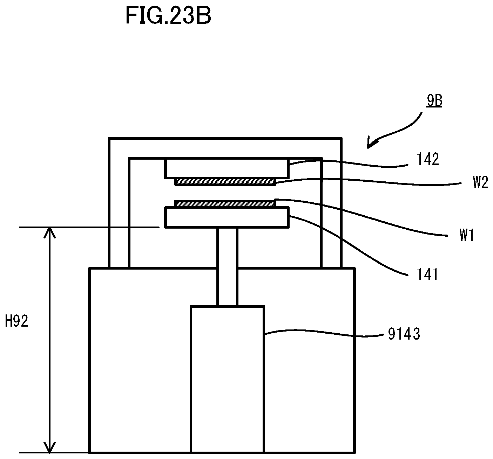

Features of the bonding device 1 according to the present embodiment are described below by comparing the bonding device 1 with bonding devices 9A and 9B according to comparative examples illustrated in FIGS 23A and 23B. In the bonding device 9A, since a head driver 9144 to drive a head 141 is located vertically directly above the head 142, height H91 from the ground to the head driver 9144 is caused to become high, as illustrated in FIG. 23A. This configuration causes vibration amplitude of the head driver 9144 and the head 142 connected to the head driver 9144 to become large, which causes relative vibration amplitude of the head 142 with respect to a stage 141 to become large. Therefore, variation in captured images acquired by imaging alignment marks MK1a, MK1b, MK2a, and MK2b disposed on both substrates W1 and W2 and variation in a contact position at which the substrates W1 and W2 are brought into contact with each other become large, which causes positional precision when the substrates W1 and W2 are bonded to each other to deteriorate. On the other hand, in the bonding device 9B, in order to avoid a head driver 9144 being arranged at a high position from the ground, a drive target is changed from a head 142 to a stage 141 and a stage driver 9143 to drive the stage 141 is arranged vertically directly below the stage 141, as illustrated in FIG. 23B. However, in the bonding device 9B, since length of the stage driver 9143 is long and the stage driver 9143 is located vertically directly below the stage 142, distance from the ground to the stage 141 is caused to become long. This configuration causes vibration amplitude of the stage driver 9143 and the stage 141 connected to the stage driver 9143 to become large, which causes relative vibration amplitude of the stage 141 with respect to the head 142 to become large. Therefore, as with the above-described configuration, variation in captured images acquired by imaging alignment marks MK1a, MK1b, MK2a, and MK2b disposed on both substrates W1 and W2 and variation in a contact position at which the substrates W1 and W2 are brought into contact with each other become large, which causes positional precision when the substrates W1 and W2 are bonded to each other to deteriorate. In addition, when a vibration isolation unit is to be arranged in the bonding device 9B, heights of the stage 141 and the head 142 from the ground are caused to become high by a height equivalent to a space in which the vibration isolation unit is arranged, which is disadvantageous in terms of configuration from a viewpoint of vibration amplitude reduction.

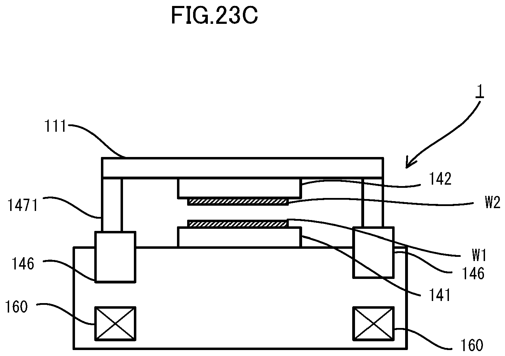

In contrast, in the bonding device 1 according to the present embodiment, the support drivers 146 are arranged on lateral sides of the stage 141 and the head 142, as illustrated in FIG. 23C. Since this configuration enables the distances between the stage 141 and the ground and between the head 142 and the ground to be decreased, the vibration amplitudes of the stage 141 and the head 142 can be reduced accordingly. In addition, in the bonding device 1, the vibration isolation unit 160 can be arranged on the - Z-direction side of the support drivers 146 in the bonding device 1 without increasing the heights of the stage 141 and the head 142 from the ground. Therefore, vibration transmitted to the stage 141 and the head 142 can be reduced.

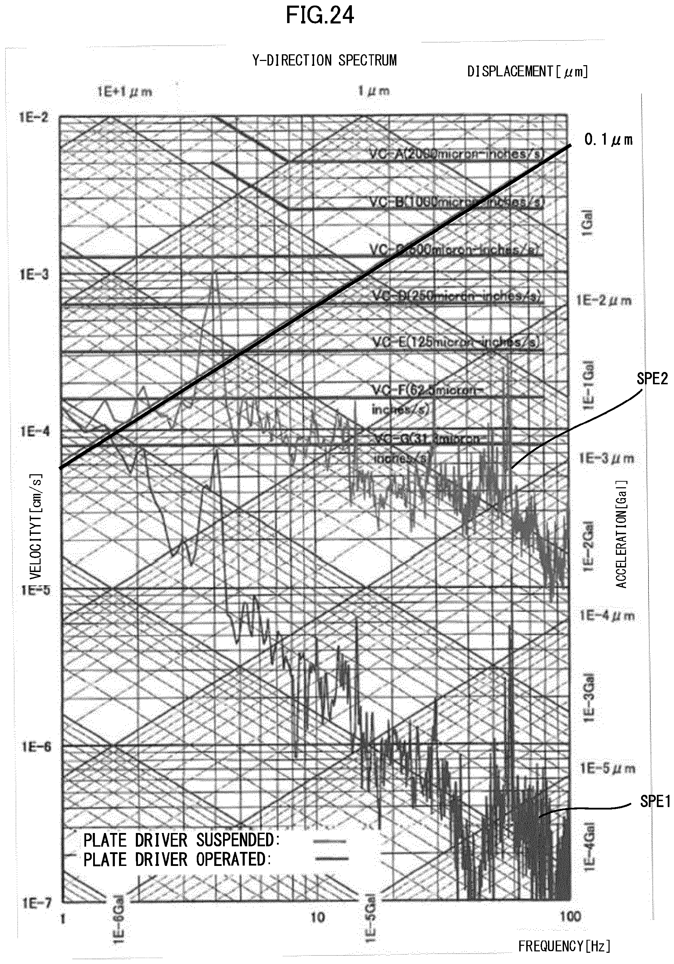

In addition, influence of the vibration isolation unit 160 on the misalignment amounts between the substrates W1 and W2 bonded to each other in the bonding device 1 is described. In FIG. 24, a frequency spectrum SPE1 indicates frequency dependence of the vibration amplitude of the stage 141 and the head 142 when the plate drivers 163 of the vibration isolation unit 160 are operating, and a frequency spectrum SPE2 indicates frequency dependence of the vibration amplitude of the stage 141 and the head 142 when operation of the plate drivers 163 of the vibration isolation unit 160 is suspended. In addition, a dashed line is a line indicating a vibration amplitude of 0.1 µm. As illustrated in FIG. 24, the amplitude of the frequency spectrum SPE2 exceeds 0.1 µm at around 6 Hz. In contrast, the amplitude of the frequency spectrum SPE1 at around 6 Hz is reduced to less than 0.1 µm.

In addition, misalignment amounts between substrates W1 and W2 are compared with one another with respect to a plurality of pairs of substrates W1 and W2 that are bonded while operation of the plate drivers 163 of the vibration isolation unit 160 is suspended and a plurality of pairs of substrates W1 and W2 that are bonded while the plate drivers 163 of the vibration isolation unit 160 are operating. As a result, it is found that while the misalignment amounts when the operation of the plate drivers 163 of the vibration isolation unit 160 is suspended are approximately 100 nm, the misalignment amounts when the plate drivers 163 of the vibration isolation unit 160 are operating are reduced to approximately 40 nm. It is considered that this result reflects the fact that the amplitude of particularly a vibration component having a frequency of around 6 Hz of the stage 141 and the head 142 being reduced to less than 0.1 µm by the vibration isolation unit 160 caused the misalignment amount between the substrates W1 and W2 bonded to each other to be reduced to 0.1 µm or less. As a result, the substrates W1 and W2 were successfully bonded to each other with high positional precision where a misalignment amount is less than or equal to 0.1 µm.

As described in the foregoing, in the bonding device 1 according to the present embodiment, each of the three holder supports 1471 supports the head holder 111 from one of three locations in the outer peripheral portion surrounding the stage 141. Each of the three support drivers 146 is arranged in the outer peripheral portion surrounding the stage 141 and individually moves one of the three holder supports 1471 in the Z-axis direction. Since this configuration enables the distances of the stage 141 and the head 142 from the ground to be decreased, the vibration amplitudes of the stage 141 and the head 142 can be reduced accordingly. Therefore, since misalignment between the substrates W1 and W2 caused by vibration transmitted from the ground is reduced, the substrates W1 and W2 can be bonded to each other with high positional precision accordingly.

In addition, the three support drivers 146 according to the present embodiment, by each individually moving one of the three holder supports 1471 in the Z-axis direction, adjust distances between three locations on the peripheral portion of the stage 142 and three locations on the head 142 each of which is opposed to one of the three locations on the stage 141. Since this configuration enables inclination of the head 142 with respect to the stage 141 to be adjusted in such a way that the head 142 becomes parallel with the stage 141, occurrence of misalignment caused by the substrate W2 being inclined with respect to the substrate W1 when the substrates W1 and W2 are brought into contact with each other can be prevented.

In a conventional configuration in which three expansion and contraction mechanisms, such as a piezo-actuator, are disposed on the head 142 side and the inclination of the head 142 is adjusted using the expansion and contraction mechanisms, since the head 142 and the expansion and contraction mechanisms operate while being in point contact with each other, the inclination adjustment has been likely to be influenced by vibration transmitted to the head 142. In contrast, in the bonding device 1 according to the present embodiment, the head 142 is connected to the holder supports 1471 via the head holder 111 and the couplers 145. This configuration enables the head 142 to be less likely to be influenced by vibration. In addition, the bonding device 1 according to the present embodiment includes the couplers 145 and the locking mechanisms 149. Because of this configuration, it is possible to perform parallelism adjustment of the head holder 111 with the locking mechanisms 149 brought into the unlocked state and, when the parallelism adjustment of the head holder 111 is finished, bring the locking mechanisms 149 into the locked state. Because of this configuration, bringing the locking mechanisms 149 into the locked state enables influence of vibration transmitted to the head 142 to be reduced.

Further, the distance measurers 185 according to the present embodiment measure distance between the head 142 and the stage 141 in the Z-axis direction at three locations on the head 142 and three locations on the stage 141. Since this configuration enables inclination of the head 142 with respect to the stage 141 to be measured with high precision, the inclination of the head 142 with respect to the stage 141 can be appropriately adjusted.

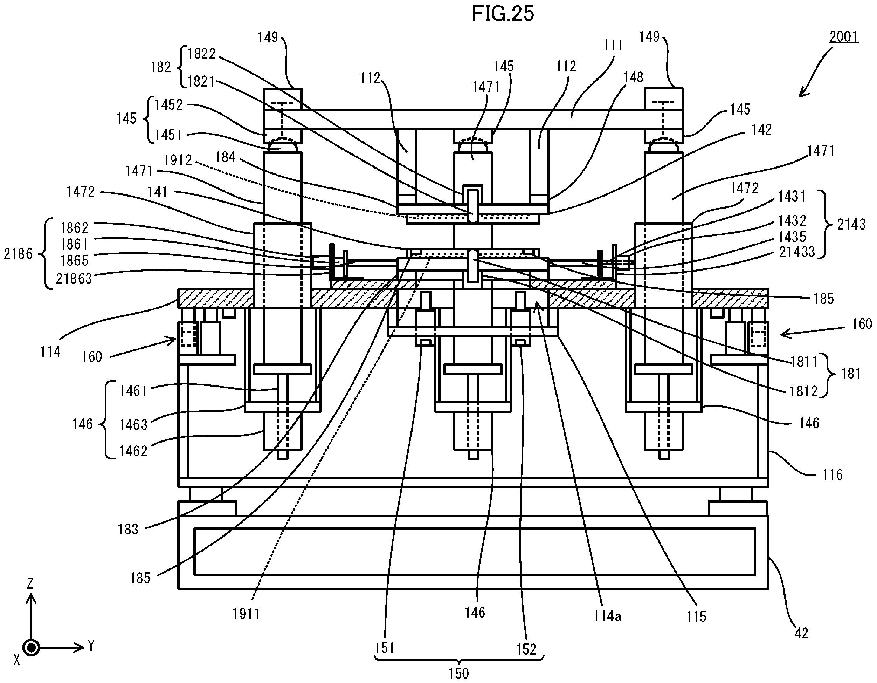

Although the embodiment of the present disclosure was described above, the present disclosure is not limited to the configuration of the aforementioned embodiment. For example, as illustrated in FIG. 25, a bonding device 2001 may be configured not to include a chamber. Note that, in FIG. 25, the same constituent components as those in the embodiment are provided with the same reference signs as those in FIG. 5. In this configuration, each of stage drivers 2143 includes a support member 1433 fixed to a top plate 114 and configured to support an actuator 1432. In addition, each of air cylinders 2186 includes a support member 21863 fixed to the top plate 114 and configured to support a cylinder tube 1862.

In the embodiment, an example in which the transportation device 84 includes the sealing member 711 that is formed in an annular shape and is arranged over the entire circumference of the frame body 712 on the side of the frame body 712 that faces the frame body 713 of the bonding device 1 was described. However, without being limited to the above example, the bonding device 1 may be, for example, a bonding device including a sealing member (not illustrated) that is formed in an annular shape and is arranged over the entire circumference of the frame body 713 on the side of the frame body 713 that faces the frame body 712 of the transportation device 84.

In the embodiment, it may be configured such that the substrates W1 and W2 are subjected to activation treatment in which only one of the two substrates W 1 and W2 is subjected to the N₂ RIE treatment and the N₂ radical treatment and the other is not subjected to at least one of the N₂ RIE treatment and the N₂ radical treatment.

In the embodiment, an example in which the bonding device 1 applies pressure to the substrates W1 and W2 and also subjects the substrates W1 and W2 to heat treatment while the entire bonding surfaces of the substrates W1 and W2 are in contact with each other was described. However, without being limited to the above example, it may be configured such that, for example, the bonding device 1 only applies pressure to the substrates W1 and W2 while the entire bonding surfaces of the substrates W1 and W2 are in contact with each other and does not perform heat treatment. Alternatively, it may be configured such that the bonding device 1 only subjects the substrates W1 and W2 to heat treatment while the entire bonding surfaces of the substrates W1 and W2 are in contact with each other and does not apply pressure to the substrates W1 and W2. In addition, the substrates W1 and W2 may be subjected to application of pressure and heat treatment in a device different from the bonding device 1. For example, the bonding device 1 may perform processing until the temporary bonding of the substrates W1 and W2 and the heat treatment may be subsequently performed in another heating device (not illustrated).

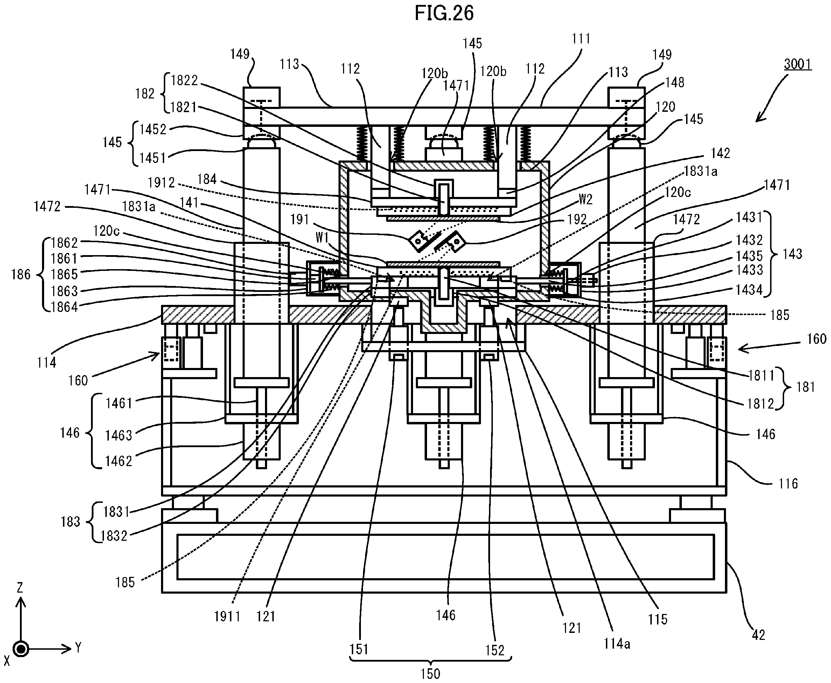

Although, in the embodiment, an example in which activation treatment to activate the bonding surfaces of the substrates W1 and W2 is performed in the activation treatment device 2 was described, the present disclosure is not limited thereto, and the bonding device 1 may be a bonding device including particle beam sources 191 and 192 that irradiate bonding surfaces of substrates W1 and W2 with particle beams in a chamber 120, as a bonding device 4001 illustrated in, for example, FIG. 26. Note that, in FIG. 26, the same constituent components as those in the embodiment are provided with the same reference signs as those in FIG. 5. As the particle beam sources 191 and 192, for example, a fast atom beam (FAB) source, an ion gun, or the like can be employed. For a bonding system according to the present variation, a configuration that does not include the load lock device 85, the transportation device 86, and the activation treatment device 2 in the bonding system according to the embodiment can be employed.

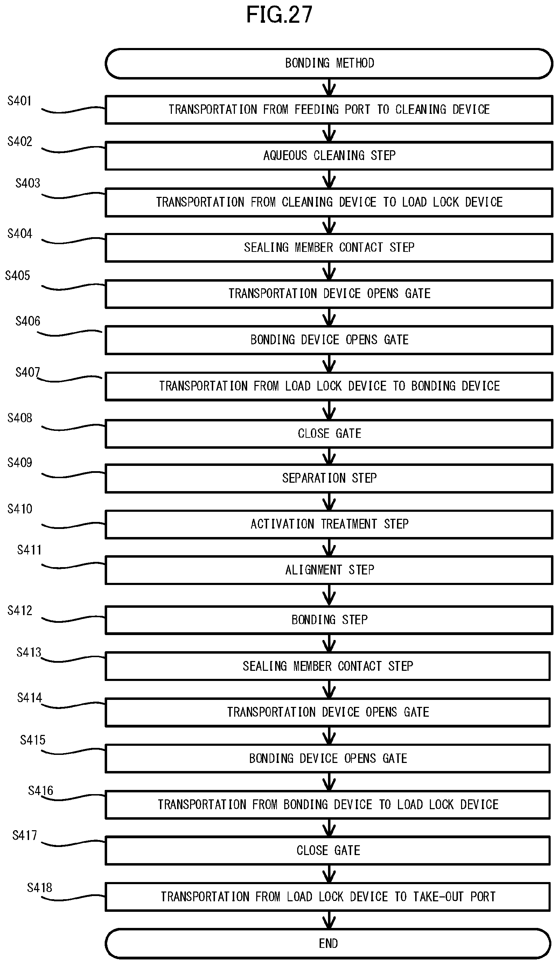

With respect to the bonding system according to the present variation, a flow of operation from when the substrates W1 and W2 are input to the bonding system to when the substrates W1 and W2 have been bonded to each other and are taken out from the bonding system is described below, referring to FIG. 27. First, the bonding system transports the substrates W1 and W2 from feeding ports 811 and 812 to a cleaning device 3, respectively (step S401). In this configuration, each of the substrates W1 and W2 is an object to be bonded formed of one of a Si substrate, an alumina substrate (Al₂O₃) including a sapphire substrate, a gallium oxide (Ga₂O₃), a nitride substrate (for example, silicon nitride (SiN), aluminum nitride (AlN), or gallium nitride (GaN)), a GaAs substrate, a silicon carbide (SiC) substrate, a lithium tantalate (Lt: LiTaO₃) substrate, a lithium niobate (Ln: LiNbO₃) substrate, a diamond substrate, and the like. Alternatively, each of the substrates W1 and W2 may be a substrate on the bonding surface of which an electrode formed of a metal, such as Au, Cu, Al, and Ti, is disposed. Next, the cleaning device 3 performs an aqueous cleaning step of cleaning the bonding surface of the substrate W1 or W2 while spraying water on the bonding surface of the substrate W1 or W2 (step S402). The processing in the aqueous cleaning step is the same as the processing in step S106 that was described in the embodiment. Succeedingly, a transportation device 82 transports the substrate W1 or W2 from the cleaning device 3 to a load lock device 83 (step S403). In this configuration, the load lock device 83 may include a substrate heater (not illustrated) to heat the transported substrates W1 and W2 and be configured to remove water adhering to the bonding surfaces of the substrates W1 and W2 by heating the transported substrates W1 and W2. Subsequently, a sealing driver 714 of a transportation device 84 performs a sealing member contact step of, by filling a filling space S71 of a sealing member 711 with gas, bringing the sealing member 711 from a second state illustrated in FIG. 2A to a first state illustrated in FIG. 2B, which were described in the embodiment (step S404). Returning to FIG. 27, next, the transportation device 84 performs a first gate opening step of opening a gate 8421 (step S405). Succeedingly, the bonding device 4001 performs a second gate opening step of opening a gate 1211 (step S406).

Next, the transportation device 84 performs a transportation step of transporting the substrates W1 and W2 from the load lock device 83 to the bonding device 4001 (step S407). Succeedingly, the bonding device 4001 closes the gate 1211 and the transportation device 84 closes the gate 8421 (step S408). Subsequently, the sealing driver 714 of the transportation device 84 performs a separation step of, by discharging gas in the filling space S71 of the sealing member 711 and thereby contracting the sealing member 711, bringing the sealing member into the second state in which the sealing member 711 is separated from a frame body 713 of the bonding device 4001 (step S409).

Next, the bonding device 4001 performs an activation treatment step of activating the bonding surface of each of the two substrates W1 and W2 while the inside of the chamber 120 is in a reduced pressure atmosphere (step S410). In this step, the bonding device 4001, by radiating particle beams emitted from the particle beam sources 191 and 192 on the bonding surfaces of the substrates W1 and W2, performs the activation treatment on the bonding surfaces of the substrates W1 and W2. Succeedingly, the bonding device 4001, after bringing the substrates W1 and W2 close to each other to a preset distance, performs an alignment step of performing positioning (alignment) of the substrate W2 with respect to the substrate W 1, based on misalignment amounts measured by a position measurer 150 (step S411). Subsequently, the bonding device 4001, after bringing the two substrates W1 and W2 into contact with each other by bringing the head 142 close to the stage 141 again, bonds the two substrates W1 and W2 to each other by applying pressure in a direction in which the two substrates W1 and W2 adhere to each other (step S412). Note that when, for example, metal regions are exposed on the bonding surfaces of the substrates W1 and W2, heat treatment of the substrates W1 and W2 may be used in combination with the bonding. In the case of the present variation, dangling bonds formed by the activation treatment exist on the bonding surfaces of the substrates W1 and W2. Because of this condition, bringing the bonding surfaces of the substrates W1 and W2 into contact with each other causes the substrates W1 and W2 to be bonded to each other via the dangling bonds.

Next, the sealing driver 714 of the transportation device 84 performs the sealing member contact step of bringing the sealing member 711 from the aforementioned second state to the aforementioned first state again (step S413). Succeedingly, after the transportation device 84 performs the first gate opening step of opening the gate 8421 (step S414), the bonding device 4001 performs the second gate opening step of opening the gate 1211 (step S415). Subsequently, the transportation device 84 transports the substrates W1 and W2 bonded to each other from the bonding device 1 to the load lock device 84 (step S416). Next, the bonding device 4001 closes the gate 1211 and the transportation device 84 closes the gate 8421 (step S417). Next, the transportation device 82 transports the substrates W1 and W2 bonded to each other from the load lock device 83 to a take-out port 813 (step S418).

Since the present configuration enables the bonding to be performed after the activation treatment step is performed while the inside of the chamber 120 is maintained in a so-called super-high vacuum state, the present configuration can be applied to direct bonding between the substrates W1 and W2 in a super-high vacuum.

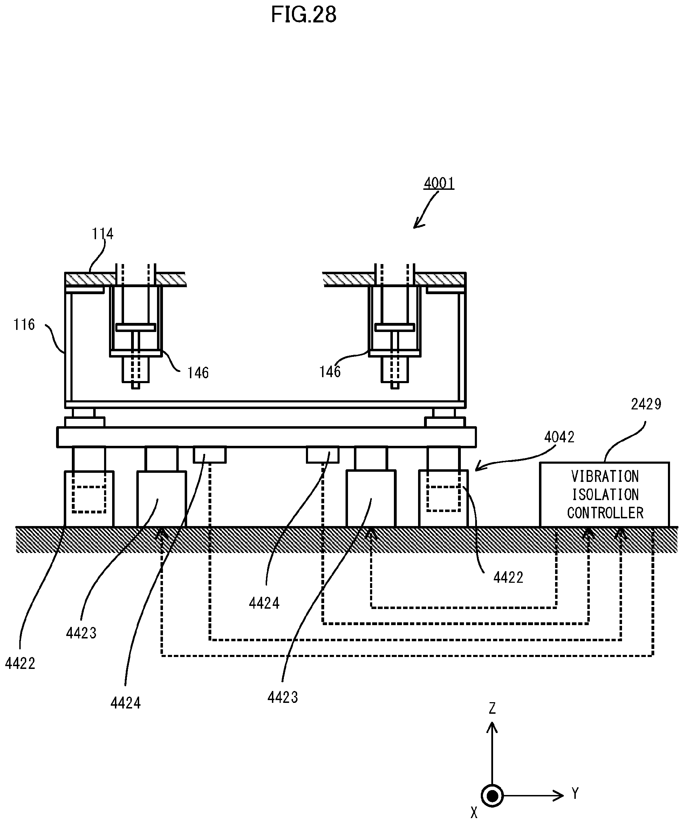

Although, in the embodiment, an example in which the bonding device 1 include the vibration isolation unit 160 was described, the present disclosure is not limited to the example, and a first platform 4042 on which a bonding device 4001 is mounted may be a so-called active vibration isolation table, as illustrated in, for example, FIG. 28. Note that, in FIG. 28, the same constituent components as those in the embodiment are provided with the same reference signs as those in FIG. 5. The bonding device 4001 differs from the bonding device 1 according to the embodiment in that the substrate bonding device 4001 does not include a vibration isolation unit. The first platform 4042 includes a top plate 4421 on the vertically upper side, that is, the +Z-direction side, of which the bonding device 4001 is mounted and plate supports 4422 each of which includes an anti-vibration mechanism, is placed on the ground, and also supports the top plate 4421 on the +Z-direction side in a freely movable manner. Each of the plate supports 4422 includes an anti-vibration mechanism using, for example, an air spring or a coil spring and supports the top plate 4421 in the Z-axis direction in a freely movable manner. In addition, the first platform 4042 further includes vibration detectors 4424 to detect vibration transmitted to the top plate 4421, plate drivers 4423 to relatively move the top plate 4421 with respect to the plate supports 2422, and a vibration isolation controller 4429 to control the plate drivers 2423 in such a manner as to reduce vibration transmitted to the top plate 4421. The plate drivers 4423 and the vibration isolation controller 4429 have similar configurations to the configurations of the plate drivers 163 and the vibration isolation controller 169 described in the embodiment, respectively.

Since the present configuration enables the bonding device 4001 to have a configuration not including a vibration isolation unit, simplification and weight reduction of the configuration of the bonding device 4001 can be achieved accordingly.

Although, in the embodiment, an example in which the vibration isolation unit 160 of the bonding device 1 is a so-called active vibration isolation table was described, the present disclosure is not limited to the example, and the vibration isolation unit 160 may be, for example, a so-called passive vibration isolation table that is configured to support a top plate 161 by supports each of which simply includes an anti-vibration mechanism, such as an air spring and a magnetic spring.

Although, in the embodiment, an example in which the stage 141 and the head 142 include the pressing mechanisms 181 and 182, respectively, was described, the present disclosure is not limited to the example, and the bonding device 1 may be a bonding device in which, for example, only the stage 141 includes the pressing mechanism 181 and the head 142 does not include a pressing mechanism. Alternatively, the bonding device 1 may be a bonding device in which only the head 142 includes the pressing mechanism 182 and the stage 141 does not include a pressing mechanism.

Although, in the embodiment, an example in which the locking mechanisms 149 can be switched between the locked state and the unlocked state during operation of the bonding device 1 was described, the present disclosure is not limited to the example, and the bonding device 1 may have a configuration in which before, for example, the bonding device 1 is started to operate, inclination of the head holder 111 is adjusted and subsequently the holder supports 1471 are fixed to the head holder 111 with bolts or the like. Even in this case, it is possible to finely adjust the inclination of the head holder 111 by an amount equivalent to bending of the head holder 111 by moving the holder supports 1471 in the Z-axis direction. Alternatively, the substrate bonding device 1 according to the embodiment may have a configuration that does not include the locking mechanisms 149. Even in this case, since the head 142 arranged in the chamber 120 can receive pressing force due to force generated by the bellows 113 fixed to the head holder 111 contracting caused by pressure in the chamber 120 being reduced, it is possible to press the substrate W2 against the substrate W1 with a certain pressure in combination with self-weight of the head 142. For example, when a so-called hydrophilic bonding in which the substrates W1 and W2 are bonded to each other by, after bringing the central portions of the substrates W1 and W2 into contact with each other while the substrates W1 and W2 are bent by pressing the central portions of the substrates W1 and W2 by the pressing mechanisms 181 and 182, bringing the substrates W1 and W2 into contact with each other over the entire bonding surfaces is employed, the substrates W1 and W2 can be bonded to each other with this level of pressure even in an environment other than a reduced pressure environment.

In the embodiment, after the central portions of the substrates W1 and W2 are butted against each other while the substrates W1 and W2 are bent by pressing the central portions of the substrates W1 and W2, the entire bonding surfaces of the substrates W1 and W2 may be pressed or only the peripheral portions of the substrates W1 and W2 may be pressed. In this case, occurrence of lifting of the peripheral portions of the substrates W1 and W2 can be prevented, and occurrence of distortion at the central portions of the substrates W1 and W2 can also be prevented. In addition, although, in the embodiment, an example in which, after the substrates W1 and W2 are butted against each other while the substrates W1 and W2 are bent by pressing the central portions of the substrates W1 and W2, the substrates W1 and W2 are bonded to each other was described, the present disclosure is not limited to the example, and the bonding device 1 may be a bonding device that, after bringing the substrates W1 and W2 into contact with each other over the entire bonding surfaces, bonds the substrates W1 and W2 to each other.

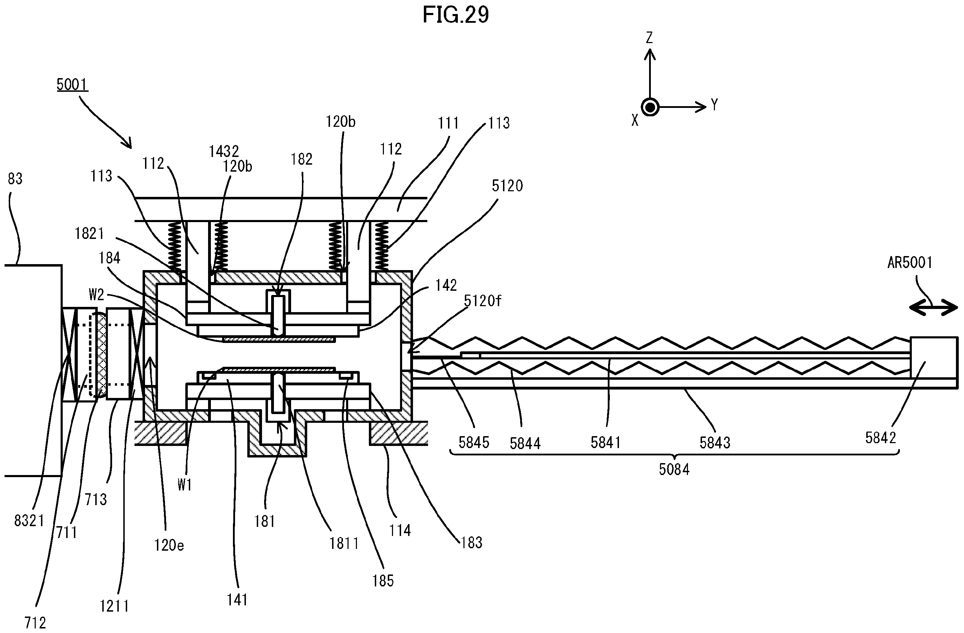

Although, in the embodiment, an example in which the transportation device 84 includes the transportation robot 841 was described, the present disclosure is not limited to the example. As illustrated in, for example, FIG. 29, a transportation device 5084 may be a transportation device including a support rod 5841 that has a long length and is inserted into an opening portion 5120f formed on a chamber 5120 of a bonding device 5001 and at one end portion of which a holder 5845 to support a substrate W1 or W2 is disposed, a support base 5842 to support the support rod 5841 at the other end portion of the support rod 5841, and a support base driver 5843 to drive the support base 5842. Note that, in FIG. 29, the same constituent components as those in the embodiment are provided with the same reference signs as those in FIG. 5. A configuration of the substrate bonding device 5001 excluding the chamber 5120 is similar to that of the substrate bonding device 1 that was described in the embodiment. The transportation device 5084 also includes a bellows 5844 interposed between the outer peripheral portion of the opening portion 5120f of the chamber 5120 and the support base 5842 in order to maintain a degree of vacuum inside the chamber 5120. The support base driver 5843 includes a rail (not illustrated) to support, for example, a slider (not illustrated) to which the support base 5842 is fixed in a freely slidable manner in the X-axis direction and a ball screw mechanism (not illustrated) to drive the slider in the X-axis direction. The support base driver 5843, by driving the support base 5842 in directions in which the support rod 5841 is inserted and removed into and from the chamber 5120 as illustrated by an arrow AR5001, transports the substrate W1 or W2 from one of a load lock device 83 and the bonding device 5001 to the other. In addition, when the transportation device 5084 is employed, the chamber 5120 of the bonding device 1 is only required to be configured to be connected to a gate 8321 of the load lock device 83 via frame bodies 712 and 713 and a sealing member 711. Note that a gate 1211 is disposed in such a manner as to cover an opening 120e of the chamber 5120.

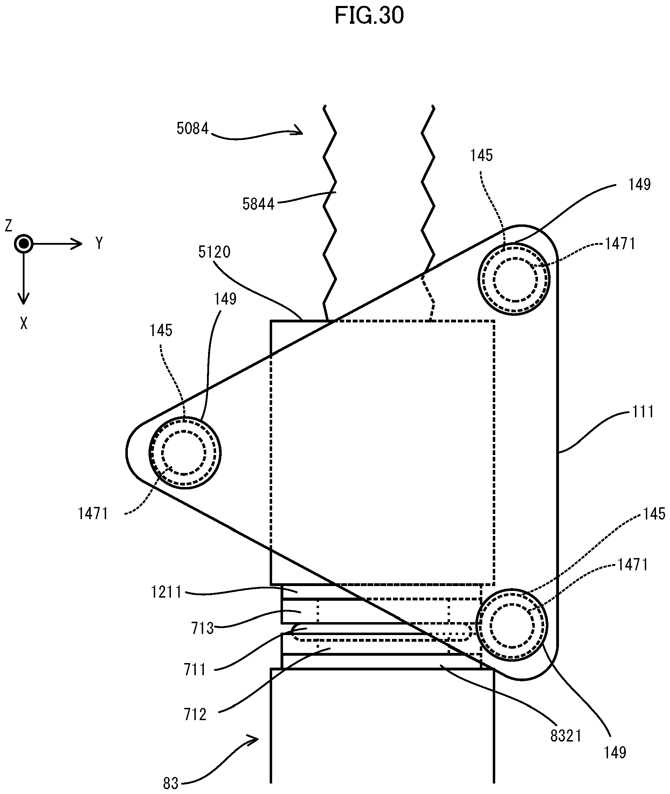

In the bonding system according to the variation that was described using FIGS. 26 and 27, the transportation device 3084 illustrated in FIG. 29 may be employed in place of the transportation device 84. In this case, as illustrated in FIG. 30, the bonding device 5001 is only required to be arranged rotated by 90 degrees in a counterclockwise direction with respect to the arrangement illustrated in FIG. 7.

According to the present configuration, since the transportation device 5084 is transportation means for which the bellows 5844 is employed, the inside of the chamber 5120 can be maintained in a so-called super-high vacuum state.

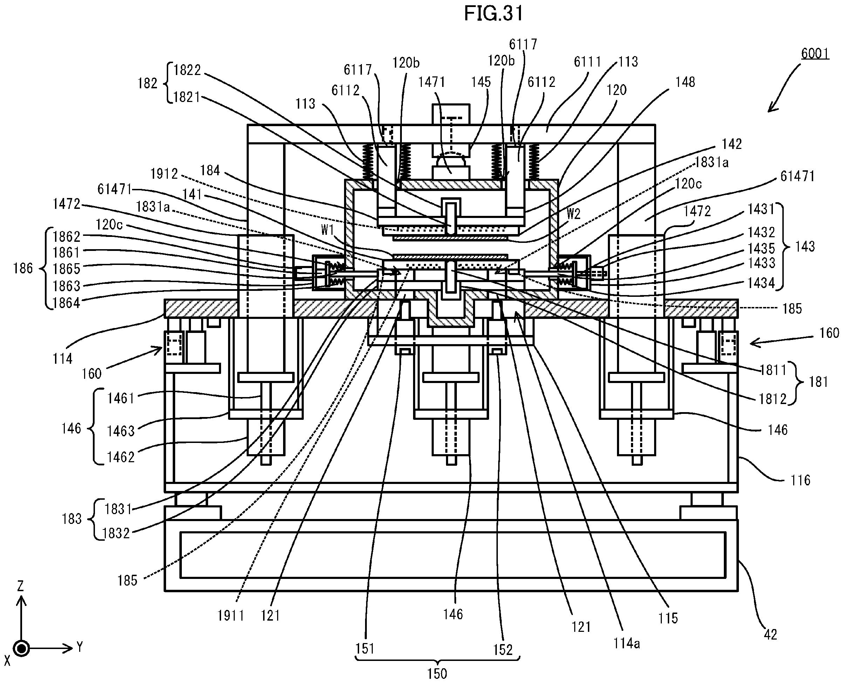

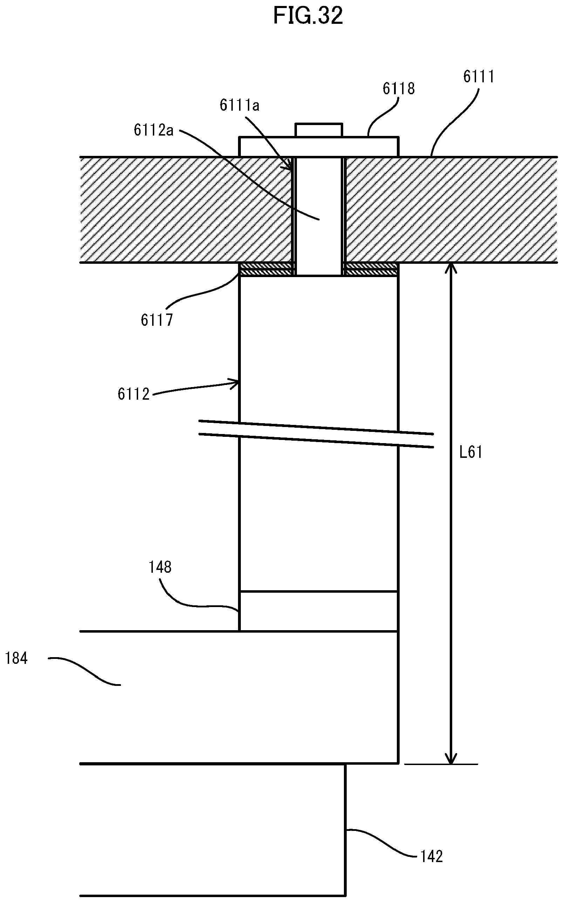

In the embodiment, an example in which the three holder supports 1471 support three corner portions of the head holder 111 via the couplers 145 was described. However, without being limited to the above example, the bonding device may be, as a bonding device 6001 illustrated in, for example, FIG. 31, a bonding device in which each of three holder supports 61471 has an end on the head holder 6111 side, that is, an end on the +Z-direction side, directly fixed to one of corner portions of the head holder 6111. In addition, the bonding device 6001 may be a bonding device including support members 6112 fixed to the head holder 6111 while supporting a head 142 and shim plates 6117 appropriately interposed between the support members 6112 and the head holder 6111. In this configuration, each of the support members 6112 includes, at an end on the +Z-direction side, a projecting portion 6112a that has a smaller diameter than a portion of the support member 6112 on the -Z-direction side of the head holder 6111 and on the sidewall of which a screw (not illustrated) is formed, as illustrated in, for example, FIG. 32. In addition, at each of positions corresponding to holder fixing portions of the head holder 6111 to which the support members 6112 are fixed, a through-hole 6111a that penetrates through the head holder 6111 in the thickness direction and into which the projecting portion 6112a of one of the support members 6112 is fitted is bored. In this configuration, length of each projecting portion 6112a is longer than thickness of the head holder 6111, and a tip portion of each projecting portion 6112a projects to the +Z-direction side of the head holder 6111. Each of the support members 6112 is fixed to the head holder 6111 by a fixing member 6118 that is placed on the +Z-direction side of the head holder 6111 and includes a nut portion (not illustrated) into which the tip portion of the projecting portion 6112a of the support member 6112 is screwed. In addition, onto each projecting portion 6112a, the shim plates 6117 can be appropriately fitted. By adjusting the number of the shim plates 6117 to be fitted onto the projecting portion 6112a of each of the support members 6112, length L61 between a head supporting portion at which the support member 6112 supports the head 142 and a holder fixing portion at which the support member 6112 is fixed to the head holder 6111 can be changed. A support member 6112, a shim plate 6117, and a fixing member 6118 described above constitute a head support member that enables the length L61 between the head supporting portion at which the support member 6112 supports the head 142 and the holder fixing portion at which the support member 6112 is fixed to the head holder 6111 to be changed.

In the bonding device 6001 according to the present variation, first, by appropriately fitting a shim plate 6117 onto the projecting portion 6112a with respect to each of the three support members 6112, the length L61 between the head supporting portion and the holder fixing portion corresponding to each of the three support member 6112 is adjusted. Through this processing, a degree of parallelism of the head 142 with respect to a stage 141 is adjusted to 5 µm or less or approximately several µm. Next, three support drivers 146, by individually moving the three holder supports 61471 in the Z-axis direction, adjust distances between three locations on the peripheral portion of the stage 141 and three locations on the head 142 each of which is opposed to one of the three locations on the stage 141 and thereby cause the head holder 6111 to bend. Through this processing, the degree of parallelism of the head 142 with respect to a stage 141 is adjusted to 1 µm or less, and preferably 0.2 µm or less. When the degree of parallelism is adjusted to 5 µm or less or approximately several µm as described above, the adjustment can be coped with by causing the head holder 6111 to bend even without a structure including the couplers 145 that can be locked and unlocked.

According to the present configuration, since the degree of parallelism of the head 142 with respect to the stage 141 can be adjusted to 0.2 µm or less, positional precision of the substrates W1 and W2 bonded to each other can be increased.

Note that, in the bonding device 6001 described using FIGS. 31 and 32, a piezo-actuator may be disposed on the head 142 side of each of the support members 6112. Because of this configuration, individually driving the piezo-actuator disposed to each of a plurality of support members 6112 enables inclination of the head 142 to be adjusted.

In the embodiment, an example in which each of the couplers 145 includes the hemispherical engaging member 1451 disposed at the end on the +Z-direction side of one of the three holder supports 1471 and the engaged member 1452 having a hemispherical recessed portion disposed on the -Z-direction side of the head holder 111 was described. However, the shape of the engaging members is not limited to a hemispherical shape. For example, the engaging members may be column-shaped or prism-shaped, and the engaged members may be engaged members each of which includes a recessed portion having a circular cross section or a rectangular cross section and having a dimension allowing an engaging member to be fitted thereinto.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

This application claims the benefit of Japanese Patent Application No. 2021-060026, filed on March 31, 2021, the entire disclosure of which is incorporated by reference herein.

### Industrial Applicability

The present disclosure is suitable for manufacturing of, for example, complementary MOS (CMOS) image sensors, memories, arithmetic elements, or micro electro mechanical systems (MEMS).

### Reference Signs List

1, 2001, 3001, 4001, 6001 Bonding device
2 Activation treatment device
3 Cleaning device
9 Controller
41 Second platform
42, 3042 First platform
82, 84, 86, 3084 Transportation device
83, 85 Load lock device
111, 6111 Head holder
112, 1433, 1463, 1863, 6112, 21433, 21863 Support member
113, 1434, 1864, 5844 Bellows
114 Top plate
115 Imager support
116 Base
120, 831, 843, 851, 863, 3120, 5120 Chamber
120b, 120c, 141b, 142b, 6111a Through-hole
120e, 5120f Opening
141 Stage
141c, 142c Recessed portion
142 Head
143, 143A, 143B, 143C, 143D Stage driver
145 Coupler
146 Support driver
148 Pressure sensor
150 Position measurer
151 First imager
152 Second imager
153 Window
154, 155 Mirror
162 Plate support
163 Plate driver
164 Vibration detector
169 Vibration isolation controller
181, 182 Pressing mechanism
183, 184 Base
185 Distance measurer
186 Air cylinder
191, 192 Particle beam source
201a Vacuum pump
201b Exhaust pipe
201c Exhaust valve
212 Treatment chamber
213 Plasma chamber
215 Induction coil
216, 217 High-frequency power source
220A Nitrogen gas feeder
220B Oxygen gas feeder
221A Nitrogen gas storage
221B Oxygen gas storage
222A, 222B Feeding valve
223A, 223B Feeding pipe
711 Sealing member
712, 713 Frame body
712a Groove
714 Sealing driver
811, 812 Feeding port
813 Take-out port
821, 841, 861 Transportation robot
1211, 8321, 8331, 8421, 8521, 8531, 8621 Gate
1212, 8322, 8332, 8422, 8522, 8532, 8622 Gate driver
1411, 1412 Electrostatic chuck
1431, 1461 Ball screw
1432, 1462 Actuator
1435, 1865 Pressing bar
1451 Engaging member
1452 Engaged member
1471, 61471 Holder support
1472 Guide
1811, 1821 Pressing rod
1812, 1822 Pressing driver
1831 Upper-side base
1831a Opening portion
1832 Lower-side base
1861 Piston rod
1862 Cylinder tube
1911, 1912 Substrate heater
5841 Support rod
5842 Support base
5843 Support base driver
5845 Holder
6112aProjecting portion
6117 Shim plate
CPR7 Compressor
CV7 Check valve
L70 Feed/discharge pipe
L71 Feed pipe
L72 Discharge pipe
M71, M72 Pressure gauge
T7 Tank
V71, V72 Electromagnetic valve
W1, W2 Substrate

## Claims

1. A bonding device for bonding a first substrate and a second substrate to each other, the bonding device comprising:
a stage to support the first substrate;
a head arranged facing the stage and configured to hold the second substrate on a side facing the stage;
a head holder to hold the head on an opposite side to the stage side of the head, the head holder extending to an outer side of the head and the stage in a direction orthogonal to an arrangement direction of the head and the stage;
a plurality of holder supports each to support the head holder from one of a plurality of locations in an outer peripheral portion surrounding the stage; and
a plurality of support drivers to individually move the plurality of holder supports in a first direction in which the head holder and the stage come close to each other or a second direction in which the head holder and the stage separate from each other.

2. The bonding device according to claim 1, wherein the plurality of support drivers each adjusts a degree of parallelism of the head with respect to the stage by adjusting distances between a plurality of locations on a peripheral portion of the stage and a plurality of locations on the head each of which is opposed to one of a plurality of locations on a peripheral portion of the stage through individually moving the plurality of holder supports in the first direction or the second direction.

3. The bonding device according to claim 1 or 2, wherein three holder supports and three support drivers exist as the plurality of holder supports and the plurality of support drivers, respectively.

4. The bonding device according to any one of claims 1 to 3 further comprising:
couplers each arranged at an end on the head holder side of one of the plurality of holder supports and configured to couple the plurality of holder supports to the head holder while the head holder is freely swingable with respect to the plurality of holder supports; and
locking mechanisms switchable between a locked state in which the locking mechanisms fix the head holder to the plurality of holder supports and an unlocked state in which the locking mechanisms maintain the head holder in a freely swingable state with respect to the plurality of holder supports.

5. The bonding device according to any one of claims 1 to 3 further comprising a plurality of head support members each fixed to the head holder while supporting the head and capable of changing length between a head supporting portion supporting the head and a holder fixing portion fixed to the head holder, wherein
an end on the head holder side of each of the plurality of holder supports is fixed to the head holder,
the plurality of head support members is capable of adjusting a degree of parallelism of the head with respect to the stage by length between the head supporting portion and the holder fixing portion of each of the plurality of head support members being adjusted, and
the plurality of support drivers each adjusts a degree of parallelism of the head with respect to the stage by adjusting distances between a plurality of locations on a peripheral portion of the stage and a plurality of locations on the head each of which is opposed to one of a plurality of locations on a peripheral portion of the stage through individually moving the plurality of holder supports in the first direction or the second direction and causing the head holder to bend.

6. The bonding device according to any one of claims 1 to 5 further comprising a distance measurer to measure distance between the head or the second substrate and the stage or the first substrate in an arrangement direction of the head and the stage at least three locations on the head.

7. The bonding device according to any one of claims 1 to 6, wherein at least one of the stage and the head includes
a pressing mechanism to cause at least one of the first substrate and the second substrate to bend in such a way that a central portion protrudes further than a peripheral portion of a bonding surface of the at least one of the first substrate and the second substrate by pressing a central portion of the at least one of the first substrate and the second substrate while a peripheral portion of the at least one of the first substrate and the second substrate is held.

8. The bonding device according to any one of claims 1 to 7 further comprising a chamber maintained in a reduce-pressure state, having the head and the stage arranged inside, and arranged in a space on an inner side of the plurality of support drivers as viewed from an arrangement direction of the head and the stage.

9. The bonding device according to any one of claims 1 to 8 comprising:
a top plate to support the stage, the head, and the plurality of support drivers; and
a plate support including an anti-vibration mechanism and configured to support the top plate on a vertically upper side in a freely movable manner.

10. The bonding device according to claim 9 comprising:
a vibration detector to detect vibration transmitted to the top plate;
a plate driver to relatively move the top plate with respect to the plate support; and
a vibration isolation controller to control the plate driver, based on the vibration detected by the vibration detector in such a way as to move the top plate in such a manner as to cancel the vibration.

11. A bonding system comprising:
a bonding device to bond a first substrate and a second substrate to each other;
a first platform on which the bonding device is mounted;
a transportation device to transport the first substrate and the second substrate to the bonding device; and
a second platform different from the first platform and on which the transportation device is mounted,
wherein the bonding device includes:
a stage to support the first substrate;
a head arranged facing the stage and configured to hold the second substrate on a side facing the stage;
a head holder extending to an outer side of the head and the stage in a direction orthogonal to an arrangement direction of the head and the stage and configured to hold the head on an opposite side to the stage side of the head;
a plurality of holder supports each to support the head holder from one of a plurality of locations in an outer peripheral portion surrounding the stage; and
a plurality of support drivers to individually move the plurality of holder supports in a first direction in which the head holder and the stage come close to each other or a second direction in which the head holder and the stage separate from each other, and
the first platform and the second platform are arranged separated from each other.

12. A bonding method for bonding a first substrate and a second substrate to each other, the bonding method comprising:
by individually moving a plurality of holder supports each to support a head holder, the head holder being arranged facing a stage to hold the first substrate, holding a head to hold the second substrate on an opposite side to the stage side of the head, and extending to an outer side of the head and the stage in a direction orthogonal to an arrangement direction of the head and the stage, from one of a plurality of locations on an outer peripheral portion surrounding the stage in a first direction in which the head holder and the stage come close to each other or a second direction in which the head holder and the stage separate from each other, adjusting distances between a plurality of locations on a peripheral portion of the stage and a plurality of locations on the head each of which is opposed to one of a plurality of locations on a peripheral portion of the stage.

13. The bonding method according to claim 12 further comprising:
a substrate holding step of causing the stage to hold the first substrate and also causing the head to hold the second substrate on a side of the head facing the stage; and
a contact step of bringing the first substrate into contact with the second substrate by individually moving the holder supports in the first direction and bringing the head relatively close to the stage.

14. The bonding method according to claim 12 or 13 further comprising an inclination adjustment step of adjusting inclination of the head with respect to the stage by adjusting distances between a plurality of locations on a peripheral portion of the stage and a plurality of locations on the head each of which is opposed to one of a plurality of locations on a peripheral portion of the stage through individually moving the plurality of holder supports in the first direction or the second direction.

15. The bonding method according to claim 12 or 13 further comprising:
a first inclination adjustment step of adjusting inclination of the head with respect to the stage by adjusting, of each of a plurality of head support members each fixed to the head holder while supporting the head and capable of changing length between a head supporting portion supporting the head and a holder fixing portion fixed to the head holder, length between the head supporting portion and the holder fixing portion; and
a second inclination adjustment step of adjusting inclination of the head with respect to the stage by adjusting distances between a plurality of locations on a peripheral portion of the stage and a plurality of locations on the head each of which is opposed to one of a plurality of locations on a peripheral portion of the stage through individually moving the plurality of holder supports in the first direction or the second direction while an end on the head holder side of each of the plurality of holder supports is fixed to the head holder and causing the head holder to bend.

16. The bonding method according to any one of claims 12 to 15,
wherein three holder supports exist as the plurality of holder supports.

17. The bonding method according to claim 14 or 15 further comprising a distance measurement step of measuring distance between the head or the second substrate and the stage or the first substrate in an arrangement direction of the head and the stage at least three locations on the head before the inclination adjustment step or during the inclination adjustment step.

18. The bonding method according to any one of claims 12 to 17 further comprising a pressing step of causing at least one of the first substrate and the second substrate to bend in such a way that a central portion protrudes further than a peripheral portion of a bonding surface of the at least one of the first substrate and the second substrate by pressing a central portion of the at least one of the first substrate and the second substrate while a peripheral portion of the at least one of the first substrate and the second substrate is held.

19. The bonding method according to any one of claims 12 to 18,
wherein the plurality of holder supports supports the head holder in a space on an outer side of the head and the stage as viewed from an arrangement direction of the head and the stage in a chamber maintained in a reduce-pressure state and having the head and the stage arranged inside.

20. The bonding method according to any one of claims 12 to 19,
wherein
the stage and the head are supported by a top plate, and
the top plate is supported by a plate support including an anti-vibration mechanism and configured to support the top plate on a vertically upper side in a freely movable manner.

21. The bonding method according to claim 20, wherein the bonding method detects vibration transmitted to the top plate and, based on the detected vibration, relatively moves the top plate with respect to the plate support in such a way as to cancel the vibration.
